# EUROPEAN PATENT APPLICATION

(11) **EP 4 779 405 A1**
(43) Date of publication of application: **22.07.2026**
(21) Application number: 24865358.6
(22) Date of filing: 05.09.2024
(51) Int. Cl.: G03F 7/004

(54) **RESIST MATERIAL AND METHOD FOR PRODUCING SAME**

(30) Priority: 11.09.2023 JP 2023147025
(71) Applicant: TOKYO OHKA KOGYO CO., LTD., Kawasaki-shi, Kanagawa 211 0012 (JP)
(72) Inventor: UNO, Kakishi, Kawasaki-shi, Kanagawa 211-0012 (JP); INARI, Takatoshi, Kawasaki-shi, Kanagawa 211-0012 (JP); KIMURA, Kenta, Kawasaki-shi, Kanagawa 211-0012 (JP); KUBO, Keisuke, Kawasaki-shi, Kanagawa 211-0012 (JP); NISHIZAWA, Akito, Kawasaki-shi, Kanagawa 211-0012 (JP); NAGATA, Masaya, Kawasaki-shi, Kanagawa 211-0012 (JP)
(74) Representative: Plasseraud IP
(86) International application number: PCT/JP2024/031893
(87) International publication number: WO 2025/057858

(57) **Abstract**

An object of the present invention is to provide a novel resist material containing a polyacid salt or a solvate thereof, a first solvent, and a second solvent and having film formability, and a method for producing the novel resist material.

## Description

### Technical Field

The present invention relates to a resist material and a method for producing it.

### Background Art

The polyacid is an anionic metal oxide cluster represented by the general formula [MₓO_{y}]ⁿ⁻ (wherein x, y, and n all denote natural numbers). The metal atom M constituting the polyacid is referred to as a polyatom and is, for example, Mo (hexavalent or pentavalent), W (hexavalent or pentavalent), V (pentavalent), Nb (pentavalent), Ta (pentavalent), or the like. The polyacid can be broadly divided into an isopolyacid composed of the polyatom M and an oxoacid, and a heteropolyacid ([X_{w}MₓO_{y}]ⁿ⁻ (wherein w, x, y, and n all denote natural numbers)) containing a different type of heteroatom X (for example, P⁵⁺, Si⁴⁺, Ge⁴⁺, B³⁺, S⁶⁺, or the like as a heteroatom X) in addition to the polyatom M and oxygen.

Isopolyacid salts and heteropolyacid salts have attracted attention as materials for optoelectronics, catalysts, and the like. If a polyacid salt or a heteropolyacid salt can be dispersed or dissolved at a high concentration in water or an organic solvent, and such a dispersion liquid or solution can have improved coatability, film formability, or the like, it can be expected that the polyacid salt or the heteropolyacid salt can be effectively used for various industrial applications by applying the dispersion liquid or solution to the surface of various parts to form a film or the like.

Patent Literature 1 discloses a metal-containing film-forming composition for extreme ultraviolet or electron beam lithography that can form a metal-containing film having good suppression of coating film thickness variation and resist sensitivity variation, wherein the composition contains a compound having a metal-oxygen covalent bond and a solvent, the solvent contains a first solvent component with a normal boiling point of less than 160°C and a second solvent component with a normal boiling point of 160°C or more and less than 400°C, the solvent contains an alcohol solvent, and the alcohol solvent content is 30% by mass.

### Citation List

### Patent Literature

PTL 1: US Patent Application Publication No. 2020/159121

### Summary of Invention

### Technical Problem

An object of the present invention is to provide a novel resist material containing a polyacid salt or a solvate thereof and a solvent and having film formability, and a method for producing the novel resist material.

### Solution to Problem

As a result of extensive studies to solve the above problems, the present inventors have completed the present invention by finding that, in a resist material containing a polyacid salt or a solvate thereof, a first solvent, and a second solvent, when the first solvent is a solvent having a dipole moment (D) per van der Waals volume (Å³) of 0.055 D/Å³ or more and a hydrogen-bonding term (ΔH) in the Hansen solubility parameter of 17 MPa^{1/2} or less, and the second solvent is a solvent different from the first solvent and is a ketone or alcohol solvent having a surface tension in the range of 20 to 35 dyne/cm and a boiling point of 165°C or less, the resist material can have film formability.

More specifically, the present invention relates to the following inventions.
<1> A resist material containing (A) a polyacid salt or a solvate thereof, (B) a first solvent, and (C) a second solvent,
   wherein the first solvent is a solvent having a dipole moment (D) per van der Waals volume (Å³) of 0.055 D/Å³ or more and a hydrogen-bonding term (ΔH) in a Hansen solubility parameter of 17 MPa^{1/2} or less, and
   the second solvent is a solvent different from the first solvent and is a ketone or alcohol solvent having a surface tension in the range of 20 to 35 dyne/cm and a boiling point of 165°C or less.
<2> The resist material according to <1>, wherein an anion moiety of the polyacid salt is an isopolyoxomolybdate anion, an isopolyoxotungstate anion, an isopolyoxoniobate anion, an isopolyoxotantalate anion, a heteropolyoxomolybdate anion, a heteropolyoxotungstate anion, a heteropolyoxovanadate anion, a heteropolyoxoniobate anion, or a heteropolyoxotantalate anion.
<3> The resist material according to <1>, wherein a boiling point difference between the first solvent and the second solvent is 50°C or less.
<4> The resist material according to <1>, wherein a boiling point difference between the first solvent and the second solvent is 30°C or less.
<5> The resist material according to <1>, wherein a cation moiety of the polyacid salt is an onium cation.
<6> The resist material according to <5>, wherein the onium cation is an organic sulfonium cation, an organic iodonium cation, an organic quaternary ammonium cation, or an organic phosphonium cation.
<7> A method for producing a resist material, the method including:
   dissolving a polyacid salt in one or more first solvents that are good solvents for the polyacid salt to prepare a good solvent solution; and
   adding a second solvent to the good solvent solution,
   wherein the first solvent is a solvent having a dipole moment (D) per van der Waals volume (Å³) of 0.055 D/Å³ or more and a hydrogen-bonding term (ΔH) in a Hansen solubility parameter of 17 MPa^{1/2} or less, and
   the second solvent is a solvent different from the first solvent and is a ketone or alcohol solvent having a surface tension in the range of 20 to 35 dyne/cm and a boiling point of 165°C or less.
<8> A method for producing a resist material, the method including:
   dissolving a polyacid salt in a first solvent to produce a solvate of the polyacid salt with the first solvent; and
   sequentially or simultaneously dissolving the solvate of the polyacid salt in a first solvent and a second solvent,
   wherein the first solvent is a solvent having a dipole moment (D) per van der Waals volume (Å³) of 0.055 D/Å³ or more and a hydrogen-bonding term (ΔH) in a Hansen solubility parameter of 17 MPa^{1/2} or less, and
   the second solvent is a solvent different from the first solvent and is a ketone or alcohol solvent having a surface tension in the range of 20 to 35 dyne/cm and a boiling point of 165°C or less.
<9> A method for producing a resist material, the method including:
   dissolving a polyacid salt in a first solvent that is a good solvent for the polyacid salt to prepare a good solvent solution;
   adding a solvent that is a poor solvent for the polyacid salt to the good solvent solution to precipitate a solvate of the polyacid salt; and
   sequentially or simultaneously dissolving the solvate of the polyacid salt in a first solvent and a second solvent,
   wherein the first solvent is a solvent having a dipole moment (D) per van der Waals volume (Å³) of 0.055 D/Å³ or more and a hydrogen-bonding term (ΔH) in a Hansen solubility parameter of 17 MPa^{1/2} or less,
   the poor solvent is a solvent having a dipole moment (D) per van der Waals volume (Å³) of less than 0.055 D/Å³ or having a hydrogen-bonding term (ΔH) in a Hansen solubility parameter of more than 17 MPa^{1/2}, and
   the second solvent is a solvent different from the first solvent and is a ketone or alcohol solvent having a surface tension in the range of 20 to 35 dyne/cm and a boiling point of 165°C or less.
<10> The method for producing a resist material according to <9>, wherein the poor solvent is a ketone solvent, an ether solvent, an ester solvent, an alcohol solvent, a hydrocarbon solvent, an aromatic hydrocarbon solvent, a heterocyclic solvent, a halogen solvent, or water.

### Advantageous Effects of Invention

The present invention can provide a novel resist material containing a polyacid salt or a solvate thereof and a solvent and having film formability, and a method for producing the novel resist material.

When a cation moiety of the polyacid salt is an onium cation, it is particularly difficult to dissolve the polyacid salt in a solvent to such an extent that a film can be formed, and the range of usable solvents is also limited. Furthermore, even when the polyacid salt was dissolved in a solvent having high solubility, it was difficult to produce a resist material having film formability that is capable of forming a film having few defects, including defects related to coatability or the like. In contrast, the present invention can provide a resist material in which a polyacid salt or a solvate thereof is satisfactorily dissolved in a solvent and that has film formability.

### Description of Embodiments

Preferred embodiments of the present invention will be described in detail below. However, the present invention is not limited to the following embodiments.

The term "solvate", as used herein, refers to a polyacid salt to which solvent molecules are bonded by a relatively weak force, such as an electrostatic interaction, a hydrogen bond, a charge transfer bond, or a coordinate bond, and the number of bonded solvent molecules may not be constant, and a plurality of solvent molecules may participate in solvation. The solvate includes a chemically acceptable solvate and includes both a stoichiometric solvate and a non-stoichiometric solvate. Such a solvate includes both a solution phase and an isolable solvate.

The term "boiling point", as used herein, refers to a normal boiling point under the condition of 1 atm (760 mmHg).

The term "halogen atom", as used herein, refers to a fluorine atom, a chlorine atom, a bromine atom, or an iodine atom.

In the present description, for example, the term "C₁₋₆" or the like means the number of carbon atoms of a group serving as a mother nucleus.

The term "C₁₋₁₈ hydrocarbylene group", as used herein, refers to a divalent hydrocarbon group formed by removing two hydrogen atoms from a hydrocarbon with 1 to 18 carbon atoms. The hydrocarbylene group may be linear, branched, or partially or fully cyclic. Examples of the hydrocarbylene group include an alkylene group and an arylene group.

A divalent carbon atom at any position of the "C₁₋₁₈ hydrocarbylene group" may be replaced by -O-, -S-, -C(=O)-, -COO-, -OCO-, -CONH-, -NHCO-, -NH(C=O)O-, -S-, -SO-, or -SO₂- (provided that adjacent divalent carbon atoms are not replaced at the same time).

The "C₁₋₁₈ hydrocarbylene group" is, for example, but not limited to, a "C₁₋₁₈ alkylene group", such as a methylene group, an ethylene group, a n-propylene group, an i-propylene group, a cyclopentadiyl group, a cyclohexanediyl group, an oxyethane-1,1-diyl group, an oxyethane-1,2-diyl group, an oxypropane-1,3-diyl group, an oxypropane-1,2-diyl group, a 2-methylpropane-1,3-diyl group, or an oxyethyleneoxyethane-1,1-diyl group; a "C₆₋₁₈ arylene group", such as a 1,4-phenylene group, a 1,3-phenylene group, a 1,2-phenylene group, a 1,4-naphthylene group, a 1,5-naphthylene group, a 1,8-naphthylene group, a 4,4'-biphenylene group, an anthracenediyl group, a phenanthrenediyl group, a naphthacenediyl group, a pyrenediyl group, a perylenediyl group, or a chrysenediyl group; or the like.

The term "C₁₋₁₈ alkyl group", as used herein, refers to a linear or branched alkyl group with 1 to 18 carbon atoms.

Furthermore, a divalent carbon atom at any position excluding the terminals contained in the "C₁₋₁₈ alkyl group" may be replaced by -O-, -C(=O)-, -C(=O)O-, -OCO-, - CONH-, -NHCO-, -NH(C=O)O-, -S-, or -SO₂-. However, adjacent divalent carbon atoms are not replaced at the same time.

The "C₁₋₁₈ alkyl group" is, for example, but not limited to, a methyl group, an ethyl group, a n-propyl group, an i-propyl group, a n-butyl group, an i-butyl group, a sec-butyl group, a t-butyl group, a n-pentyl group, an i-pentyl group, a sec-pentyl group, a t-pentyl group, a neopentyl group, a 1-methylbutyl group, a 2-methylbutyl group, a 1,1-dimethylpropyl group, a 1,2-dimethylpropyl group, a n-hexyl group, an i-hexyl group, a 1-methylpentyl group, a 2-methylpentyl group, a 3-methylpentyl group, a 1,1-dimethylbutyl group, a 1,2-dimethylbutyl group, a 2,2-dimethylbutyl group, a 1,3-dimethylbutyl group, a 2,3-dimethylbutyl group, a 3,3-dimethylbutyl group, a 1-ethylbutyl group, a 2-ethylbutyl group, a 1,1,2-trimethylpropyl group, a 1,2,2-trimethylpropyl group, a 1-ethyl-1-methylpropyl group, a 1-ethyl-2-methylpropyl group, a n-heptyl group, a n-octyl group, a n-nonyl group, a n-decyl group, a n-undecyl group, a n-dodecyl group, or the like.

The "C₁₋₁₈ alkyl group" in which a divalent carbon atom at any position excluding the terminals thereof is replaced by -O-, -C(=O)-, -C(=O)O-, -OCO-, -CONH-, -NHCO-, - NH(C=O)O-, -S-, or -SO₂- is, for example, but not limited to, a 2-methoxyethoxymethyl group, an ethoxycarbonylmethyl group, or the like.

The term "C₁₋₁₈ haloalkyl group", as used herein, refers to a group in which one or more hydrogen atoms of the "C₁₋₁₈ alkyl group" are substituted by a halogen atom.

The "C₁₋₁₈ haloalkyl group" is, for example, but not limited to, a dichloromethyl group, a trifluoromethyl group, a 2,2-difluoroethyl group, a 2,2,2-trifluoroethyl group, a pentafluoroethyl group, a 3,3,3-trifluoropropyl group, or the like.

The term "C₂₋₁₈ alkenyl group", as used herein, refers to an alkenyl group with 2 or more carbon atoms having one or more double bonds in the "C₁₋₁₈ alkyl group" and includes an alkadienyl group, an alkatrienyl group, and the like.

The "C₂₋₁₈ alkenyl group" is, for example, but not limited to, a vinyl group (ethenyl group), an allyl group (2-propenyl group), a 1-propenyl group, an isopropenyl group (1-methyl vinyl group), a 1-butenyl group, a 2-butenyl group, a 3-butenyl group, a pentenyl group, a hexenyl group, a heptenyl group, an octenyl group, a nonenyl group, a decenyl group, an undecenyl group, a dodecenyl group, or the like.

The term "C₂₋₁₈ alkynyl group", as used herein, refers to an alkynyl group with 2 or more carbon atoms having one or more triple bonds in the "C₁₋₁₈ alkyl group".

The "C₂₋₁₈ alkynyl group" is, for example, but not limited to, an ethynyl group, a 1-propynyl group, a 2-propynyl group, a pentynyl group, a hexynyl group, a heptynyl group, an octynyl group, a nonynyl group, a decynyl group, an undecynyl group, a dodecynyl group, or the like.

The term "C₃₋₁₈ alicyclic group", as used herein, refers to a hydrocarbon group with 3 to 18 carbon atoms and with a monocyclic or polycyclic structure in whole or in part. The alicyclic group includes a cycloalkyl group, a cycloalkenyl group, a cycloalkynyl group, a monocycloalkyl group, a polycycloalkyl group, and the like.

A divalent carbon atom at any position excluding the terminals contained in the "C₃₋₁₈ alicyclic group" may be replaced by -O-, -C(=O)-, -C(=O)O-, -OCO-, -CONH-, -NHCO-, -NH(C=O)O-, -S-, or -SO₂- (provided that adjacent divalent carbon atoms are not replaced at the same time).

The "C₃₋₁₈ cycloalkyl group" is, for example, but not limited to, a cyclopropyl group, a cyclobutyl group, a cyclopentyl group, a 1-i-propylcyclopentane-1-yl group, a cyclohexyl group, a t-butylcyclohexyl group, a tricyclodecanyl group, a cycloheptyl group, a cyclooctyl group, a cyclodecyl group, a 2-methyladamantane-2-yl group, a 2-i-propyladamantane-2-yl group, a bornyl group, a norbonyl group, a fenchyl group, a pinanyl group, an adamantyl group, a tricyclodecyl group, a tetracyclododecyl group, a cyclopropylmethyl group, a cyclobutylmethyl group, a cyclopentylmethyl group, a cyclohexylmethyl group, a bornylmethyl group, a norbornylmethyl group, an adamantylmethyl group, a 1-methylcyclopentyloxycarbonylmethyl group, a cyclopentenyl group, a cyclohexenyl group, a cycloheptenyl group, or the like.

The term "3- to 18-membered non-aromatic heterocyclic group", as used herein, refers to a 3- to 18-membered non-aromatic heterocyclic group containing one or more heteroatoms selected from the group consisting of a nitrogen atom, an oxygen atom, and a sulfur atom, may be monocyclic, polycyclic, or condensed, and may be saturated or partially unsaturated.

The "3- to 18-membered non-aromatic heterocyclic group" is, for example, but not limited to, an aziridinyl group, an azetidil group, a pyrrolidinyl group, a pyrrolyl group, a piperidinyl group, a piperazinyl group, a morpholinyl group, a thiomorpholinyl group, a tetrahydrofuryl group, a tetrahydropyranyl group, an oxetanyl group, a tetrahydrofuryl group, a tetrahydropyranyl group, an imidazolinyl group, an oxazolinyl group, a 2,5-diazabicyclo[2.2.1]heptyl group, a 2,5-diazabicyclo[2.2.2]octyl group, a 3,8-diazabicyclo[3.2.1]octyl group, a 1,4-diazabicyclo[4.3.0]nonyl group, a 1-azaadamantyl group, a 2-azaadamantyl group, or the like.

The term "C₂₋₁₈ aryl group", as used herein, refers to an aromatic hydrocarbon ring group with 6 to 18 carbon atoms or an aromatic heterocyclic group with 2 to 10 carbon atoms; in the case of an aromatic heterocyclic group, 2 to 10 carbon atoms and one or more heteroatoms selected from the group consisting of a nitrogen atom, an oxygen atom, and a sulfur atom form a ring, and the ring may be monocyclic, polycyclic, or a fused ring.

The "C₂₋₁₈ aryl group" is, for example, but not limited to, a phenyl group, a 1-naphthyl group, a 2-naphthyl group, an azulenyl group, a pentalenyl group, a heptalenyl group, an indacenyl group, an acenaphthyl group, a phenanthrenyl group, an anthracenyl group, or the like.

The term "C₇₋₁₈ aralkyl group", as used herein, refers to a group in which a substitutable portion of a "C₁₋₁₂ alkyl group" is substituted by the "C₂₋₁₂ aryl group".

The "C₇₋₁₈ aralkyl group" is, for example, but not limited to, a benzyl group, a phenethyl group, a 3-phenylpropyl group, a 4-phenylbutyl group, a 1-naphthylmethyl group, or a 2-naphthylmethyl group, or the like.

The term "C₁₋₁₈ hydrocarbyl group", as used herein, refers to a monovalent group formed by removing one hydrogen atom from a hydrocarbon with 1 to 18 carbon atoms. Examples of the hydrocarbyl group include an alkyl group, an alkenyl group, an alkynyl group, an alicyclic group, an aryl group, an aralkyl group, and the like.

A divalent carbon atom at any position excluding the terminals contained in the "C₁₋₁₈ hydrocarbyl group" may be replaced by -O-, -C(=O)-, -C(=O)O-, -OCO-, -CONH-, - NHCO-, -NH(C=O)O-, -S-, or -SO₂- (provided that adjacent divalent carbon atoms are not replaced at the same time). The same applies to the "C₁₋₁₈ hydrocarbyl group" and the like used in the following description of the definition of the "C₁₋₁₈ hydrocarbyloxy group" and the like.

The "C₁₋₁₈ hydrocarbyl group" is, for example, but not limited to, a "C₁₋₁₈ alkyl group", a "C₂₋₁₈ alkenyl group", a "C₂₋₁₈ alkynyl group", a "C₃₋₁₈ alicyclic group", a "C₂₋₁₈ aryl group", a "C₇₋₁₈ aralkyl group", or the like.

The term "C₁₋₁₈ hydrocarbyloxy group", as used herein, refers to a group in which an oxygen atom (-O-) is bonded to the "C₁₋₁₈ hydrocarbyl group".

The "C₁₋₁₈ hydrocarbyloxy group" is, for example, but not limited to, a "C₁₋₁₈ alkoxy group", such as a methoxy group, an ethoxy group, a n-propoxy group, an i-propoxy group, a n-butoxy group, an i-butoxy group, a sec-butoxy group, a t-butoxy group, a n-pentoxy group, an i-pentoxy group, a sec-pentoxy group, a n-hexoxy group, an i-hexoxy group, a 1,1-dimethylpropyloxy group, a 1,2-dimethylpropyloxy group, a 2,2-dimethylpropyloxy group, a 1-methyl-2-ethylpropyloxy group, a 1-ethyl-2-methylpropyloxy group, a 1,1,2-trimethylpropyloxy group, a 1,2,2-trimethylpropyloxy group, a 1,1-dimethylbutyloxy group, a 1,2-dimethylbutyloxy group, a 2,2-dimethylbutyloxy group, a 2,3-dimethylbutyloxy group, a 1,3-dimethylbutyloxy group, a 2-ethylbutyloxy group, a 2-methylpentyloxy group, or a 3-methylpentyloxy group; a "C₃₋₁₈ alicyclic oxy group", such as a cyclopropyloxy group, a cyclobutyloxy group, a cyclopentyloxy group, a cyclohexyloxy group, a cycloheptyloxy group, a cyclooctyloxy group, a 1-methylcyclopentyloxycarbonylmethoxy group, a 1-ethylcyclohexyloxycarbonylmethoxy group, or a 1-methyladamantyloxycarbonylmethoxy group; a "C₆₋₁₈ aryloxy group", such as a phenyloxy group, a 1-naphthyloxy group, a 2-naphthyloxy group, an azulenyloxy group, a pentalenyloxy group, a heptalenyloxy group, an indacenyloxy group, an acenaphthyloxy group, a phenanthrenyloxy group, or an anthracenyloxy group; or the like.

In the "C₁₋₁₈ hydrocarbyloxy group", a divalent carbon atom at any position excluding the terminals in the "C₁₋₁₈ hydrocarbyl group" is preferably replaced by -O-, - C(=O)-, and/or -C(=O)O-, the "C₁₋₁₈ hydrocarbyloxy group" is more preferably a "C₁₋₁₈ hydrocarbyloxycarbonylalkyloxy group", and from the perspective of solubility, a carbon atom bonded to the oxygen atom of the hydrocarbyloxy is still more preferably a tertiary carbon. Specific examples of the hydrocarbyloxy include optionally substituted ethylcyclopentyloxy, methyladamantyloxy, ethyladamantyloxy, t-butyloxy, and the like.

The term "C₁₋₁₈ hydrocarbylcarbonyl group", as used herein, refers to a group in which a carbonyl group (-C(=O)-) is bonded to the "C₁₋₁₈ hydrocarbyl group".

The "C₁₋₁₈ hydrocarbylcarbonyl group" is, for example, but not limited to, a "C₁₋₁₈ alkyl carbonyl group", such as an acetyl group, a propionyl group, an isopropionyl group, a butyryl group, an isobutyryl group, a valeryl group, an isovaleryl group, a pentanoyl group, a 3-methylbutanoyl group, a pivaloyl group, a hexanoyl group, or a heptanoyl group; a "C₃₋₁₈ alicyclic carbonyl group", such as a cyclopropyl carbonyl group, a cyclobutyl carbonyl group, a cyclopentyl carbonyl group, a 2-methylcyclopentyl carbonyl group, a 3-methylcyclopentyl carbonyl group, a cyclohexyl carbonyl group, a 2-methylcyclohexyl carbonyl group, a 3-methylcyclohexyl carbonyl group, a 4-methylcyclohexyl carbonyl group, or an adamantyl carbonyl group; a "C₆₋₁₈ aryl carbonyl group", such as a benzoyl group, a 1-naphthoyl group, or a 2-naphthoyl group; or the like.

The term "C₁₋₁₈ hydrocarbylcarbonyloxy group", as used herein, refers to a group in which an oxygen atom (-O-) is bonded to the "C₁₋₁₈ hydrocarbylcarbonyl group". The "C₁₋₁₈ hydrocarbylcarbonyloxy group" is, for example, but not limited to, a "C₁₋₁₈ alkyl carbonyloxy group", such as a methyl carbonyloxy group, an ethyl carbonyloxy group, a n-propyl carbonyloxy group, an isopropyl carbonyloxy group, a n-butyl carbonyloxy group, an isobutyl carbonyloxy group, a t-butyl carbonyloxy group, a n-pentyl carbonyloxy group, an isopentyl carbonyloxy group, or a hexyl carbonyloxy group; a "C₃₋₁₈ alicyclic carbonyloxy group", such as a cyclopropyl carbonyloxy group, a cyclobutyl carbonyloxy group, a cyclopentyl carbonyloxy group, or a cyclohexyl carbonyloxy group; a "C₆₋₁₈ aryl carbonyloxy group", such as a phenyl carbonyloxy group, a naphthyl carbonyloxy group, an acenaphthyl carbonyloxy group, a phenanthrenyl carbonyloxy group, or an anthracenyl carbonyloxy group; or the like.

The term "C₁₋₁₈ hydrocarbyloxycarbonyl group", as used herein, refers to a group in which a carbonyl group (-C(=O)-) is bonded to a "C₁₋₁₈ hydrocarbyloxy group".

The "C₁₋₁₈ hydrocarbyloxycarbonyl group" is, for example, but not limited to, a "C₁₋₁₈ alkoxycarbonyl group", such as a methoxycarbonyl group, an ethoxycarbonyl group, a n-propoxycarbonyl group, an i-propoxycarbonyl group, a n-butoxycarbonyl group, an i-butoxycarbonyl group, a sec-butoxycarbonyl group, a t-butoxycarbonyl group, a n-pentoxycarbonyl group, or a neopentyloxycarbonyl group; a "C₃₋₁₈ alicyclic oxycarbonyl group", such as a cyclopropyloxycarbonyl group, a cyclobutyloxycarbonyl group, a cyclopentyloxycarbonyl group, a cyclohexyloxycarbonyl group, a 2-methylcyclopentyloxycarbonyl group, a 3-methylcyclopentyloxycarbonyl group, a 2-methylcyclohexyloxycarbonyl group, a 3-methylcyclohexyloxycarbonyl group, or a 4-methylcyclohexyloxycarbonyl group; a "C₆₋₁₈ aryloxycarbonyl group", such as a phenoxycarbonyl group, a naphthoxycarbonyl group, an acenaphthyloxycarbonyl group, a phenanthrenyloxycarbonyl group, or an anthracenyloxycarbonyl group; or the like.

The term "C₁₋₁₈ hydrocarbyloxycarbonyloxy group", as used herein, refers to a group in which an oxygen atom (-O-) is bonded to the "C₁₋₁₈ hydrocarbyloxycarbonyl group".

The "C₁₋₁₈ hydrocarbyloxycarbonyloxy group" is, for example, but not limited to, a "C₁₋₁₈ alkoxycarbonyloxy group", such as a methoxycarbonyloxy group, an ethoxycarbonyloxy group, a n-propyloxycarbonyloxy group, an i-propyloxycarbonyloxy group, a n-butoxycarbonyloxy group, an i-butoxycarbonyloxy group, a sec-butoxycarbonyloxy group, a t-butoxycarbonyloxy group, a n-pentyloxycarbonyloxy group, an i-pentyloxycarbonyloxy group, or a n-hexyloxycarbonyloxy group; a "C₃₋₁₈ alicyclic oxycarbonyloxy group", such as a cyclopropyloxycarbonyloxy group, a cyclobutyloxycarbonyloxy group, a cyclopentyloxycarbonyloxy group, or a cyclohexyloxycarbonyloxy group; a "C₆₋₁₈ aryloxycarbonyloxy group", such as a phenoxycarbonyloxy group, a naphthoxycarbonyloxy group, an acenaphthyloxycarbonyloxy group, a phenanthrenyloxycarbonyloxy group, or an anthracenyloxycarbonyloxy group; or the like.

The term "C₁₋₁₈ hydrocarbylamino group", as used herein, refers to a group in which one "C₁₋₁₈ hydrocarbyl group" is bonded to an amino group.

The "C₁₋₁₈ hydrocarbylamino group" is, for example, but not limited to, a "C₁₋₁₈ alkylamino group", such as a methylamino group, an ethylamino group, a n-propylamino group, an i-propylamino group, a n-butylamino group, an i-butylamino group, a sec-butylamino group, a t-butylamino group, a n-pentylamino group, an i-pentylamino group, a neopentylamino group, or a n-hexylamino group; a "C₃₋₁₈ alicyclic amino group", such as a cyclopropylamino group, a cyclobutylamino group, a cyclopentylamino group, a 2-methylcyclopentylamino group, a 3-methylcyclopentylamino group, a cyclohexylamino group, a 2-methylcyclohexylamino group, a 3-methylcyclohexylamino group, or a 4-methylcyclohexylamino group; a "C₆₋₁₈ arylamino group", such as a phenylamino group, a 1-naphthylamino group, or a 2-naphthylamino group; or the like.

The term "di-C₁₋₁₈ hydrocarbylamino group", as used herein, refers to a group in which two identical or different "C₁₋₁₈ hydrocarbyl groups" are bonded to an amino group.

The "di-C₁₋₁₈ hydrocarbylamino group" is, for example, but not limited to, a "di-C₁₋₁₈ alkylamino group", such as a dimethylamino group, a diethylamino group, a di-n-propylamino group, a diisopropylamino group, a di-n-butylamino group, a diisobutylamino group, a di-t-butylamino group, a di-n-pentylamino group, a di-n-hexylamino group, an N-ethyl-N-methylamino group, an N-methyl-N-n-propylamino group, an N-isopropyl-N-methylamino group, an N-n-butyl-N-methylamino group, an N-isobutyl-N-methylamino group, an N-t-butyl-N-methylamino group, an N-methyl-N-n-pentylamino group, an N-n-hexyl-N-methylamino group, an N-ethyl-N-n-propylamino group, an N-ethyl-N-isopropylamino group, an N-n-butyl-N-ethylamino group, an N-ethyl-N-isobutylamino group, an N-t-butyl-N-ethylamino group, an N-ethyl-N-n-pentylamino group, or an N-ethyl-N-n-hexylamino group; a "di-C₃₋₁₈ alicyclic amino group", such as a dicyclopropylamino group, a dicyclobutylamino group, a dicyclopentylamino group, or a dicyclohexylamino group; a "di-C₆₋₁₈ arylamino group", such as a diphenylamino group or a phenylnaphthylamino group; an "N-C₁₋₁₈ alkyl-N-C₃₋₁₈ cycloalkylamino group", such as an N-methylcyclopentaneamino group or an N-methylcyclohexylamino group; an "N-C₁₋₁₈ alkyl-N-C₆₋₁₈ arylamino group", such as an N-methyl-2-phenylethylamino group or an N-ethyl-N-(4-methylphenyl)amino group; or the like.

The term "C₁₋₁₈ hydrocarbylaminocarbonyl group", as used herein, refers to a group in which a carbonyl group (-C(=O)-) is bonded to the "C₁₋₁₈ hydrocarbylamino group".

The "C₁₋₁₈ hydrocarbylaminocarbonyl group" is, for example, but not limited to, a "C₁₋₁₈ alkylaminocarbonyl group", such as a methylaminocarbonyl group, an ethylaminocarbonyl group, a n-propylaminocarbonyl group, an i-propylaminocarbonyl group, a n-butylaminocarbonyl group, a sec-butylaminocarbonyl group, a t-butylaminocarbonyl group, a n-pentylaminocarbonyl group, a 2-pentylaminocarbonyl group, a neopentylaminocarbonyl group, a 4-methyl-2-pentylaminocarbonyl group, a n-hexylaminocarbonyl group, or a 3-methyl-n-pentylaminocarbonyl group; a "C₃₋₁₈ alicyclic aminocarbonyl group", such as a cyclopropylaminocarbonyl group, a cyclobutylaminocarbonyl group, a cyclopentylaminocarbonyl group, a cyclohexylaminocarbonyl group, a 2-methylcyclopentylaminocarbonyl group, a 3-methylcyclopentylaminocarbonyl group, a 2-methylcyclohexylaminocarbonyl group, a 3-methylcyclohexylaminocarbonyl group, or a 4-methylcyclohexylaminocarbonyl group; or a "C₆₋₁₈ arylaminocarbonyl group", such as a phenylaminocarbonyl group, a 1-naphthylaminocarbonyl group, or a 2-naphthylaminocarbonyl group.

The term "di-C₁₋₁₈ hydrocarbylaminocarbonyl group", as used herein, refers to a group in which a carbonyl group (-C(=O)-) is bonded to a "di-C₁₋₁₈ hydrocarbylamino group".

The "di-C₁₋₁₈ hydrocarbylaminocarbonyl group" is, for example, but not limited to, a "di-C₁₋₁₈ alkylamino group", such as a dimethylaminocarbonyl group, a diethylaminocarbonyl group, a di-n-propylaminocarbonyl group, a diisopropylaminocarbonyl group, a di-n-butylaminocarbonyl group, a diisobutylaminocarbonyl group, a di-t-butylaminocarbonyl group, a di-n-pentylaminocarbonyl group, a di-n-hexylaminocarbonyl group, an N-ethyl-N-methylaminocarbonyl group, an N-methyl-N-n-propylaminocarbonyl group, an N-isopropyl-N-methylaminocarbonyl group, an N-n-butyl-N-methylaminocarbonyl group, an N-isobutyl-N-methylaminocarbonyl group, an N-t-butyl-N-methylaminocarbonyl group, an N-methyl-N-n-pentylaminocarbonyl group, an N-n-hexyl-N-methylaminocarbonyl group, an N-ethyl-N-n-propylaminocarbonyl group, an N-ethyl-N-isopropylaminocarbonyl group, an N-n-butyl-N-ethylaminocarbonyl group, an N-ethyl-N-isobutylaminocarbonyl group, an N-t-butyl-N-ethylaminocarbonyl group, an N-ethyl-N-n-pentylaminocarbonyl group, or an N-ethyl-N-n-hexylaminocarbonyl group; a "di-C₃₋₁₈ alicyclic aminocarbonyl group", such as a dicyclopropylaminocarbonyl group, a dicyclobutylaminocarbonyl group, a dicyclopentylaminocarbonyl group, or a dicyclohexylaminocarbonyl group; a "di-C₆₋₁₈ arylaminocarbonyl group", such as a diphenylaminocarbonyl group or a phenylnaphthylaminocarbonyl group; or the like.

The term "C₁₋₁₈ hydrocarbylcarbonylamino group", as used herein, refers to a group in which an amino group is bonded to the "C₁₋₁₈ hydrocarbylcarbonyl group".

The "C₁₋₁₈ hydrocarbylcarbonylamino group" is, for example, but not limited to, a "C₁₋₁₈ alkyl carbonylamino group", such as a methyl carbonylamino group, an ethyl carbonylamino group, a n-propyl carbonylamino group, an i-propyl carbonylamino group, a n-butyl carbonylamino group, an i-butyl carbonylamino group, a sec-butyl carbonylamino group, a t-butyl carbonylamino group, a n-pentyl carbonylamino group, an i-pentyl carbonylamino group, or a n-hexyl carbonylamino group; a "C₃₋₁₈ alicyclic carbonylamino group", such as a cyclopropyl carbonylamino group, a cyclobutyl carbonylamino group, a cyclopentyl carbonylamino group, or a cyclohexyl carbonylamino group; a "C₆₋₁₈ aryl carbonylamino group", such as a phenyl carbonylamino group, a naphthyl carbonylamino group, an acenaphthyl carbonylamino group, a phenanthrenyl carbonylamino group, or an anthracenyl carbonylamino group; or the like.

The term "C₁₋₁₈ hydrocarbylaminocarbonyloxy group", as used herein, refers to a group in which an oxygen atom (-O-) is bonded to the "C₁₋₁₈ hydrocarbylaminocarbonyl group".

The "C₁₋₁₈ hydrocarbylaminocarbonyloxy group" is, for example, but not limited to, a "C₁₋₁₈ alkylaminocarbonyloxy group", such as a methylaminocarbonyloxy group, an ethylaminocarbonyloxy group, or a n-propylaminocarbonyloxy group; a "C₃₋₁₈ alicyclic aminocarbonyloxy group", such as a cyclopropylaminocarbonyloxy group or a cyclohexylaminocarbonyloxy group; a "C₆₋₁₈ arylaminocarbonyloxy group", such as a phenylaminocarbonyloxy group or a 1-naphthylaminocarbonyloxy group; or the like.

The term "di-C₁₋₁₈ hydrocarbylaminocarbonyloxy group", as used herein, refers to a group in which an oxygen atom (-O-) is bonded to the "di-C₁₋₁₈ hydrocarbylaminocarbonyl group".

The "di-C₁₋₁₈ hydrocarbylaminocarbonyloxy group" is, for example, but not limited to, a "di-C₁₋₁₈ alkylaminocarbonyloxy group", such as a dimethylaminocarbonyloxy group, a diethylaminocarbonyloxy group, or a di-n-propylaminocarbonyloxy group; or the like.

The term "C₁₋₁₈ hydrocarbylaminocarbonylamino group", as used herein, refers to a group in which the "C₁₋₁₈ hydrocarbylaminocarbonyl group" is bonded to an amino group.

The "C₁₋₁₈ hydrocarbylaminocarbonylamino group" is, for example, but not limited to, a "C₁₋₁₈ alkylaminocarbonylamino group", such as a methylaminocarbonylamino group, an ethylaminocarbonyloxy group, or a n-propylaminocarbonylamino group; a "C₃₋₁₈ alicyclic aminocarbonylamino group", such as a cyclopropylaminocarbonylamino group or a cyclohexylaminocarbonylamino group; a "C₆₋₁₈ arylaminocarbonylamino group", such as a phenylaminocarbonylamino group or a 1-naphthylaminocarbonylamino group; or the like.

The term "di-C₁₋₁₈ hydrocarbylaminocarbonylamino group", as used herein, refers to a group in which a "di-C₁₋₁₈ hydrocarbylaminocarbonyl group" is bonded to an amino group.

The "di-C₁₋₁₈ hydrocarbylaminocarbonylamino group" is, for example, but not limited to, a "di-C₁₋₁₈ alkylaminocarbonylamino group", such as a dimethylaminocarbonylamino group, a diethylaminocarbonylamino group, or a di-n-propylaminocarbonylamino group; or the like.

The term "C₁₋₁₈ hydrocarbyloxycarbonylamino group", as used herein, refers to a group in which the "C₁₋₁₈ hydrocarbyloxycarbonyl group" is bonded to an amino group.

The "C₁₋₁₈ hydrocarbyloxycarbonylamino group" is, for example, but not limited to, a "C₁₋₁₈ alkoxycarbonylamino group", such as a methoxycarbonylamino group, an ethoxycarbonylamino group, a n-propoxycarbonylamino group, an i-propoxycarbonylamino group, a n-butoxycarbonylamino group, or a t-butoxycarbonylamino group; a "C₃₋₁₈ alicyclic oxycarbonylamino group", such as a cyclopropyloxycarbonylamino group or a cyclohexyloxycarbonylamino group; a "C₆₋₁₈ aryloxycarbonylamino group", such as a phenyloxycarbonylamino group or a 1-naphthyloxycarbonylamino group; or the like.

The term "C₁₋₁₈ hydrocarbylthio group", as used herein, refers to a group in which a sulfur atom (-S-) is bonded to the "C₁₋₁₈ hydrocarbyl group".

The "C₁₋₁₈ hydrocarbylthio group" is, for example, but not limited to, a "C₁₋₁₈ alkylthio group", such as a methylthio group, an ethylthio group, a n-propylthio group, an i-propylthio group, a n-butylthio group, an i-butylthio group, a t-butylthio group, a n-pentylthio group, or a n-hexylthio group; a "C₃₋₁₈ alicyclic thio group", such as a cyclopropylthio group, a cyclobutylthio group, a cyclopentylthio group, a cyclohexylthio group, a 2-methylcyclopentylthio group, a 3-methylcyclopentylthio group, a 2-methylcyclohexylthio group, a 3-methylcyclohexylthio group, or a 4-methylcyclohexylthio group; a "C₆₋₁₈ arylthio group", such as a phenylthio group, a 1-naphthylthio group, a 2-naphthylthio group, an acenaphthylthio group, a phenanthrenylthio group, or an anthracenylthio group; or the like.

The term "C₁₋₁₈ hydrocarbylsulfinyl group", as used herein, refers to a group in which a sulfinyl group (-S(=O)-) is bonded to the "C₁₋₁₈ hydrocarbyl group".

The "C₁₋₁₈ hydrocarbylsulfinyl group" is, for example, but not limited to, a "C₁₋₁₈ alkylsulfinyl group", such as a methylsulfinyl group, an ethylsulfinyl group, a n-propylsulfinyl group, an i-propylsulfinyl group, a n-butylsulfinyl group, a t-butylsulfinyl group, a pentylsulfinyl group, or a hexylsulfinyl group; a "C₃₋₁₈ alicyclic sulfinyl group", such as a cyclopropylsulfinyl group, a cyclobutylsulfinyl group, a cyclopentylsulfinyl group, a cyclohexylsulfinyl group, a 2-methylcyclopentylsulfinyl group, a 3-methylcyclopentylsulfinyl group, a 2-methylcyclohexylsulfinyl group, a 3-methylcyclohexylsulfinyl group, or a 4-methylcyclohexylsulfinyl group; a "C₆₋₁₈ arylsulfinyl group", such as a phenylsulfinyl group, a naphthylsulfinyl group, an acenaphthylsulfinyl group, a phenanthrenylsulfinyl group, or an anthracenylsulfinyl group; or the like.

The term "C₁₋₁₈ hydrocarbylsulfonyl group", as used herein, refers to a group in which a sulfonyl group (-SO₂-) is bonded to the "C₁₋₁₈ hydrocarbyl group".

The "C₁₋₁₈ hydrocarbylsulfonyl group" is, for example, but not limited to, a "C₁₋₁₈ alkylsulfonyl group", such as a methylsulfonyl group, an ethylsulfonyl group, a n-propylsulfonyl group, an i-propylsulfonyl group, a n-butylsulfonyl group, a t-butylsulfonyl group, or a pentylsulfonyl group; a "C₃₋₁₈ alicyclic sulfonyl group", such as a cyclopropylsulfonyl group, a cyclobutylsulfonyl group, a cyclopentylsulfonyl group, a cyclohexylsulfonyl group, a 2-methylcyclopentylsulfonyl group, a 3-methylcyclopentylsulfonyl group, a 2-methylcyclohexylsulfonyl group, a 3-methylcyclohexylsulfonyl group, or a 4-methylcyclohexyl group; a "C₆₋₁₈ arylsulfonyl group", such as a phenylsulfonyl group, a naphthylsulfonyl group, an acenaphthylsulfonyl group, a phenanthrenylsulfonyl group, or an anthracenylsulfonyl group; or the like.

The term "acid-dissociable group", as used herein, refers to a group that substitutes a hydrogen atom of a carboxy group or a hydroxy group (including a phenolic hydroxy group or the like) and is dissociated by the action of an acid.

The term "acid-dissociable group" is, for example, but not limited to, a t-butyl group, a t-amyl group, a 1,1-dimethylpropyl group, a 1-methyl-1-cyclopentyl group, a 1-ethyl-1-cyclopentyl group, a 1-methyl-1-cyclohexyl group, a 1-ethyl-1-cyclohexyl group, a 2-methyl-2-adamantyl group, a 2-ethyl-2-adamantyl group, a 1-(1-methoxy-2-methylpropan-2-yl)cyclopentyl group, a 1-(1-ethoxy-2-methylpropan-2-yl)cyclopentyl group, or the like.

The phrase "may have a substituent", as used herein, is not particularly limited provided that it is chemically acceptable and has the advantages of the present invention.

The "substituent" is, for example, (1) a halogen atom, (2) a hydroxy group, (3) a thiol group, (4) a nitro group, (5) a cyano group, (6) a carboxy group, (7) an amino group, (8) a sulfo group, (9) a group in which a hydrogen atom of a carboxy group or a hydroxy group is substituted by an acid-dissociable group, or (10) a C₁₋₈ hydrocarbyl group, a C₁₋₈ hydrocarbyloxy group, a C₁₋₈ hydrocarbylcarbonyl group, a C₁₋₈ hydrocarbylcarbonyloxy group, a C₁₋₈ hydrocarbyloxycarbonyl group, a C₁₋₈ hydrocarbyloxycarbonyloxy group, a C₁₋₈ hydrocarbylamino group, a di-C₁₋₈ hydrocarbylamino group, a C₁₋₈ hydrocarbylaminocarbonyl group, a di-C₁₋₈ hydrocarbylaminocarbonyl group, a C₁₋₈ hydrocarbylcarbonylamino group, a C₁₋₈ hydrocarbylaminocarbonyloxy group, a di-C₁₋₈ hydrocarbylaminocarbonyloxy group, a C₁₋₈ hydrocarbylaminocarbonylamino group, a di-C₁₋₈ hydrocarbylaminocarbonylamino group, a C₁₋₈ hydrocarbyloxycarbonylamino group, a C₁₋₈ hydrocarbylthio group, a C₁₋₈ hydrocarbylsulfinyl group, or a C₁₋₈ hydrocarbylsulfonyl group, in which at least part of its hydrogen atoms may be substituted by (1) to (9), a divalent carbon atom at any position excluding the terminals of the substituent may be replaced by - O-, -C(=O)-, -C(=O)O-, -OCO-, -CONH-, -NHCO-, -NH(C=O)O-, -S-, or -SO₂- (provided that adjacent divalent carbon atoms are not replaced at the same time), or the like.

### [1. Resist Material]

A resist material according to the present embodiment contains a polyacid salt or a solvate thereof, a first solvent, and a second solvent. The first solvent is a solvent having a dipole moment (D) per van der Waals volume (Å³) of 0.055 D/Å³ or more and a hydrogen-bonding term (ΔH) in the Hansen solubility parameter of 17 MPa^{1/2} or less. The second solvent is a solvent different from the first solvent and is a ketone or alcohol solvent having a surface tension in the range of 20 to 35 dyne/cm and a boiling point of 165°C or less.

The "polyacid salt" and the "first solvent and second solvent" will be described in more detail below.

### [1-1. Polyacid Salt]

The polyacid salt used in the present embodiment may be, but is not limited to, a known and commonly used polyacid salt. The polyacid salt may be a solvate of the polyacid salt from the perspective of improving the solubility in a solvent. The polyacid salt is composed of an anion moiety of an isopolyacid anion or a heteropolyacid anion and a cation moiety that is a counter cation thereto.

The "anion moiety of the polyacid salt", the "cation moiety of the polyacid salt", the "solvate of the polyacid salt", and the like will be described below.

### [1-1-1. Anion Moiety of Polyacid Salt]

The anion moiety of the polyacid salt is composed of an isopolyacid anion or a heteropolyacid anion.

The isopolyacid anion is, for example, an isopolyoxomolybdate anion, an isopolyoxotungstate anion, an isopolyoxovanadate anion, an isopolyoxoniobate anion, an isopolyoxotantalate anion, or the like.

The isopolyoxomolybdate anion is, for example, [MoO₄]²⁻, [Mo₇O₂₄]⁶⁻, [Mo₈O₂₆]⁴⁻, or the like. The isopolyoxotungstate anion is, for example, [W₄O₁₃]²⁻, [W₅O₁₆]²⁻, [W₆O₁₉]²⁻, [W₇O₂₂]²⁻, [W₇O₂₄]⁶⁻, [H_{z}W₁₂O₄₀]^{-(8-z)} (wherein z denotes an integer in the range of 1 to 4), [W₁₀O₃₂]⁴⁻, [H₄W₁₁O₃₈]⁶⁻, [H₇W₁₁O₄₀]⁷⁻, [HW₅O₁₉]⁷⁻, [H₃W₁₁O₂₂]⁵⁻, or the like. The isopolyoxovanadate anion is, for example, [V₄O₁₂]⁴⁻, [V₁₀O₂₈]⁶⁻, or the like, the isopolyoxoniobate anion is, for example, [Nb₆O₁₉]⁸⁻, [Nb₁₀O₂₈]⁶⁻, or the like, and the isopolyoxotantalate anion is, for example, [Ta₆O₁₉]⁸⁻, [Ta₈O₂₁]²⁻, or the like.

The isopolyoxomolybdate anion, the isopolyoxotungstate anion, the isopolyoxovanadate anion, the isopolyoxoniobate anion, and the isopolyoxotantalate anion include various isomers and the like.

The heteropolyacid anion is, for example, a heteropolyoxomolybdate anion, a heteropolyoxotungstate anion, a heteropolyoxovanadate anion, a heteropolyoxoniobate anion, a heteropolyoxotantalate anion, or the like.

The heteropolyoxomolybdate anion is, for example, a phosphomolybdate anion, a silicomolybdate anion, a boromolybdate anion, a phosphotungstomolybdate anion, a cobalt molybdate anion, an arsenic molybdate anion, a germanium molybdate anion, or the like. The heteropolyoxotungstate anion is, for example, a phosphotungstate anion, a silicotungstate anion, a borotungstate anion, a cobalt tungstate anion, an arsenic tungstate anion, a germanium tungstate anion, or the like. The heteropolyoxovanadate anion is, for example, a phosphomolybdovanadate anion, a phosphomolybdotungstomolybdate anion, a boromolybdovanadate anion, a boromolybdotungstovanadate anion, or the like.

The heteropolyoxomolybdate anion, the heteropolyoxotungstate anion, the heteropolyoxovanadate anion, and the like include a Keggin type, a Dawson type, an Anderson type, and deficient species and isomers thereof.

### [1-1-2. Cation Moiety of Polyacid Salt]

The type of the salt of the polyacid salt (isopolyoxometalate or heteropolyoxometalate) may be, but is not limited to, a salt with a proton, an onium cation (for example, an organic onium cation, an organic sulfonium cation, an organic iodonium cation, an organic quaternary ammonium cation, an organic phosphonium cation, or the like), an alkali metal ion, or the like. From the perspective of improving actinic ray sensitivity or radiation sensitivity, the type of salt of the polyacid salt is preferably a salt with an onium cation, and the onium cation is preferably an onium cation having at least one unsaturated bond that may have a substituent, the unsaturated bond is, for example, a carbon-carbon double bond or a carbon-carbon triple bond, and among these, a carbon-carbon double bond is more preferred, and a benzene ring is still more preferred. The onium cation is, for example, an organic sulfonium cation, an organic iodonium cation, an organic quaternary ammonium cation, an organic phosphonium cation, or the like.

### [1-1-2-1. Organic Sulfonium Cation]

The organic sulfonium cation is not particularly limited and may be a known and commonly used organic sulfonium cation. The organic sulfonium cation is, for example, an organic sulfonium cation represented by the formula (I).

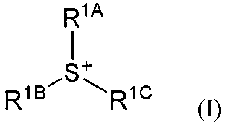

In the formula (I), R^{1A}, R^{1B}, and R^{1C} each independently denote a C₁-₁₈ hydrocarbyl group, a 3- to 18-membered non-aromatic heterocyclic group, or a 5- to 18-membered aromatic heterocyclic group,
a divalent carbon atom at any position except the end(s) of R^{1A}, R^{1B}, and R^{1C} may be replaced by -O-, -C(=O)-, -C(=O)O-, -OCO-, -CONH-, -NHCO-, -NH(C=O)O-, -S-, or - SO₂- (provided that adjacent divalent carbon atoms are not replaced at the same time),
a hydrogen atom in R^{1A}, R^{1B}, and R^{1C} may be substituted by, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, or (j) a C₁-₁₈ hydrocarbyl group, a C₁-₁₈ hydrocarbyloxy group, a C₁-₁₈ hydrocarbylcarbonyl group, a C₁-₁₈ hydrocarbylcarbonyloxy group, a C₁-₁₈ hydrocarbyloxycarbonyl group, a C₁-₁₈ hydrocarbyloxycarbonyloxy group, or a C₁-₁₈ hydrocarbylthio group, in which at least part of a hydrogen atom may be substituted by (a) to (i), and a divalent carbon atom at any position except the ends of these substituents may be replaced by -O-, -C(=O)-, -C(=O)O-, -OCO-, -CONH-, -NHCO-, -NH(C=O)O-, -S-, or -SO₂- (provided that adjacent divalent carbon atoms are not replaced at the same time); and
any two of R^{1A}, R^{1B}, and R^{1C} may be linked to each other directly by a single bond or via a divalent linking group -O-, -S-, -C(=O)-, -S(=O)-, -S(=O)₂-, -C(=O)O-, or a C₁₋₃ alkylene group to form a ring together with a sulfur atom in the formula (I).

R^{1A}, R^{1B} and R^{1C} in the formula (I) preferably each independently denote an optionally substituted C₆₋₁₈ aryl group. A substituent for the C₆₋₁₈ aryl group is preferably a halogen atom, a haloalkyl group, a hydroxy group, a nitro group, a cyano group, an optionally substituted C₁₋₁₂ hydrocarbyl group, C₁₋₁₂ hydrocarbyloxy group, C₁₋₁₂ hydrocarbylcarbonyl group, C₁₋₁₂ hydrocarbylcarbonyloxy group, C₁₋₁₂ hydrocarbyloxycarbonyl group, C₁₋₁₂ hydrocarbyloxycarbonyloxy group, or a C₁-₁₂ hydrocarbylthio group, more preferably a halogen atom, a C₁₋₄ haloalkyl group, a nitro group, or a C₁₋₈ hydrocarbyloxy group.

Specific examples of the organic sulfonium cation include a dibutyl(pentyl)sulfonium cation, a triethylsulfonium cation, (2-carboxyethyl)dimethylsulfonium cation, a trimethylsulfonium cation, a dimethylphenacylsulfonium cation, a 1-(4-hydroxynaphthalen-1-yl)hexahydrothiopyrylium cation, a dimethylphenylsulfonium cation, a triphenylsulfonium cation, a tris(4-methylphenyl)sulfonium cation, a 4-methoxyphenyldiphenylsulfonium cation, a 4-iodophenyldiphenylsulfonium cation, a tris(4-fluorophenyl)sulfonium cation, a 1-phenylhexahydrothiopyrylium cation, an (ethane-1,2-diylbisoxy)bis(4,1-phenylene)bis(diphenylsulfonium) dication, a (thiodi-4,1-phenylene)bis(diphenylsulfonium) dication, a di(naphthalen-1-yl)(phenyl)sulfonium cation, a phenyl bis(2-(trifluoromethyl)phenyl)sulfonium cation, a mesityl bis(2-(trifluoromethyl)phenyl)sulfonium cation, a bis(3,5-difluorophenyl)(phenyl)sulfonium cation, a tris(3,5-difluorophenyl)sulfonium cation, a (4-(dodecanoyloxy-3,5-dimethylphenyl))diphenylsulfonium cation, a diphenyl(3-(trifluoromethoxy)phenyl)sulfonium cation, a (4-(1-adamantylcarbonyloxy)phenyl)diphenylsulfonium cation, a (4-phenylthiophenyl)diphenylsulfonium cation, a 5-phenyl-5H-thianthren-5-ium cation, a 5-(2,5-dimethylphenyl)thianthren-5-ium cation, a 5-phenyl-5H-dibenzo[b,d]thiophen-5-ium cation, a 5-(3-(trifluoromethyl)phenyl)-5H-dibenzo[b,d]thiophen-5-ium cation, a 1-(4-(t-butyl)phenyl)-1H-benzo[b]thiophen-1-ium cation, a methyldiphenylsulfonium cation, a (2-bromoethyl)diphenylsulfonium cation, a (3-chloropropyl)diphenylsulfonium cation, a benzyl(4-hydroxyphenyl)methylsulfonium cation, a (4-hydroxyphenyl)methyl(2-methylbenzyl)sulfonium cation, a 4-hydroxyphenyldimethylsulfonium cation, a diphenyl(methyl)sulfonium cation, a diphenyl(4-(phenylthio)phenyl)sulfonium cation, a dimesityl(trifluoromethyl)sulfonium cation, and a tri-p-tolylsulfonium cation.

### [1-1-2-2. Organic Iodonium Cation]

The organic iodonium cation is not particularly limited and may be a known and commonly used organic iodonium cation. The organic iodonium cation is, for example, an organic iodonium cation represented by the formula (II).

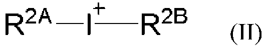

In the formula (II), R^{2A} and R^{2B} each independently denote a C₁-₁₈ hydrocarbyl group, a 3- to 18-membered non-aromatic heterocyclic group, or a 5- to 18-membered aromatic heterocyclic group
a divalent carbon atom at any position except the end(s) of R^{2A} and R^{2B} may be replaced by -O-, -C(=O)-, -C(=O)O-, -OCO-, -CONH-, -NHCO-, -NH(C=O)O-, -S-, or - SO₂- (provided that adjacent divalent carbon atoms are not replaced at the same time);
a hydrogen atom in R^{2A} and R^{2B} may be substituted by, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, or (j) a C₁-₁₈ hydrocarbyl group, a C₁-₁₈ hydrocarbyloxy group, a C₁-₁₈ hydrocarbylcarbonyl group, a C₁-₁₈ hydrocarbylcarbonyloxy group, a C₁-₁₈ hydrocarbyloxycarbonyl group, or a C₁-₁₈ hydrocarbyloxycarbonyloxy group, in which at least part of a hydrogen atom may be substituted by (a) to (i), and a divalent carbon atom at any position except the ends of these substituents may be replaced by -O-, -C(=O)-, -C(=O)O-, -OCO-, -CONH-, -NHCO-, - NH(C=O)O-, -S-, or -SO₂- (provided that adjacent divalent carbon atoms are not replaced at the same time); and
furthermore, R^{2A} and R^{2B} may be linked to each other directly by a single bond or via a divalent linking group -O-, -S-, -C(=O)-, -S(=O)-, -S(=O)₂-, -C(=O)O-, or a C₁₋₃ alkylene group to form a ring together with the iodine atom in the formula (II).

R^{2A} and R^{2B} in the formula (II) preferably each independently denote an optionally substituted C₆₋₁₈ aryl group. A substituent for the C₆₋₁₈ aryl group is preferably a halogen atom, a haloalkyl group, a hydroxy group, a nitro group, a cyano group, an optionally substituted C₁₋₁₂ hydrocarbyl group, C₁₋₁₂ hydrocarbyloxy group, C₁₋₁₂ hydrocarbylcarbonyl group, C₁₋₁₂ hydrocarbylcarbonyloxy group, C₁₋₁₂ hydrocarbyloxycarbonyl group, or C₁₋₁₂ hydrocarbyloxycarbonyloxy group, preferably a halogen atom, a C₁₋₄ haloalkyl group, a nitro group, a C₁₋₈ hydrocarbyl group, or a C₁₋₈ hydrocarbyloxy group.

Specific examples of the iodonium cations include an ethynyl(phenyl)iodonium cation, a bis(pyridine)iodonium cation, a bis(2,4,6-trimethylpyridine)iodonium cation, a diphenyliodonium cation, a bis(4-(t-butyl)phenyl)iodonium cation, a (2-carboxyphenyl)(phenyl)iodonium cation, a (4-nitrophenyl)(phenyl)iodonium cation, a (3-(trifluoromethyl)phenyl)(2,4,6-trimethylphenyl)iodonium cation, a bis(4-fluorophenyl)iodonium cation, a (4-(bromomethyl)phenyl)(2,4,6-trimethoxyphenyl)iodonium cation, a 4-biphenylyl(2,4,6-trimethoxyphenyl)iodonium cation, a bis(2,4,6-trimethylphenyl)iodonium cation, a 4-isopropyl-4'-methyldiphenyliodonium cation, a (4-(trifluoromethyl)phenyl)(2,4,6-trimethylphenyl)iodonium cation, a ((4-trifluoromethyl)phenyl)(2,4,6-trimethoxyphenyl)iodonium cation, a (5-fluoro-2-nitrophenyl)(2,4,6-trimethoxyphenyl)iodonium cation, a (3-bromophenyl)(mesityl)iodonium cation, a bis(4-bromophenyl)iodonium cation, a (3,5-dichlorophenyl)(2,4,6-trimethoxyphenyl)iodonium cation, a (4-methylphenyl)(2,4,6-trimethylphenyl)iodonium cation, a (3-methylphenyl)(2,4,6-trimethylphenyl)iodonium cation, a (2-methylphenyl)(2,4,6-trimethylphenyl)iodonium cation, a phenyl(2,4,6-trimethoxyphenyl)iodonium cation, and the like.

### [1-1-2-3. Organic Quaternary Ammonium Cation]

The organic quaternary ammonium cation is not particularly limited and may be a known and commonly used organic quaternary ammonium cation. The organic quaternary ammonium cation is, for example, an organic quaternary ammonium cation represented by the formula (III).

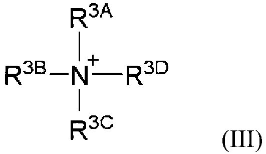

In the formula (III), R^{3A}, R^{3B}, R^{3C}, and R^{3D} each independently denote a C₁-₁₈ hydrocarbyl group, a 3- to 18-membered non-aromatic heterocyclic group, or a 5- to 18-membered aromatic heterocyclic group,
a divalent carbon atom at any position except the end(s) of R^{3A}, R^{3B}, R^{3C}, and R^{3D} may be replaced by -O-, -C(=O)-, -C(=O)O-, -OCO-, -CONH-, -NHCO-, -NH(C=O)O-, - S-, or -SO₂- (provided that adjacent divalent carbon atoms are not replaced at the same time),
a hydrogen atom in R^{3A}, R^{3B}, R^{3C}, and R^{3D} may be substituted by, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, or (j) a C₁-₁₈ hydrocarbyl group, a C₁-₁₈ hydrocarbyloxy group, a C₁-₁₈ hydrocarbylcarbonyl group, a C₁-₁₈ hydrocarbylcarbonyloxy group, a C₁-₁₈ hydrocarbyloxycarbonyl group, a C₁-₁₈ hydrocarbyloxycarbonyloxy group, or a C₁-₁₈ hydrocarbylthio group, in which at least part of a hydrogen atom may be substituted by (a) to (i), and a divalent carbon atom at any position except the ends of these substituents may be replaced by -O-, -C(=O)-, -C(=O)O-, -OCO-, -CONH-, -NHCO-, -NH(C=O)O-, -S-, or -SO₂- (provided that adjacent divalent carbon atoms are not replaced at the same time); and
any two of R^{3A}, R^{3B}, R^{3C}, and R^{3D} may be linked to each other directly by a single bond or via a divalent linking group -O-, -S-, -C(=O)-, -S(=O)-, -S(=O)₂-, -C(=O)O-, or a C₁₋₃ alkylene group to form a ring together with a nitrogen atom in the formula (III).

R^{3A}, R^{3B}, R^{3C}, and R^{3D} in the formula (III) preferably each independently denote an optionally substituted C₁-₁₈ hydrocarbyl group, more preferably a C₁₋₁₂ alkyl group, a C₁₋₁₂ alkenyl group, a C₁₋₁₂ alkynyl group, or a C₁₋₁₂ alicyclic group.

Specific examples of the organic quaternary ammonium cation include a tetramethylammonium cation, a tetraethylammonium cation, a tetrapropylammonium cation, a tetrabutylammonium cation, a tetraheptylammonium cation, a tetrahexylammonium cation, a trimethylethylammonium cation, a dimethyldiethylammonium cation, a dimethylethylpropylammonium cation, a methylethylpropylbutylammonium cation, a trimethylphenylammonium cation, a triethylhexylammonium cation, a triethylcyclohexylammonium cation, and a dodecyltrimethylammonium cation.

### [1-1-2-4. Organic Phosphonium Cation]

The organic phosphonium cation may be, but is not limited to, a known and commonly used organic phosphonium cation. The organic phosphonium cation is, for example, an organic phosphonium cation represented by the formula (IV).

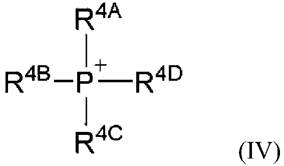

In the formula (IV), R^{4A}, R^{4B}, R^{4C}, and R^{4D} each independently denote a C₁-₁₈ hydrocarbyl group, a 3- to 18-membered non-aromatic heterocyclic group, or a 5- to 18-membered aromatic heterocyclic group,
a divalent carbon atom at any position except the end(s) of R^{4A}, R^{4B}, R^{4C}, and R^{4D} may be replaced by -O-, -C(=O)-, -C(=O)O-, -OCO-, -CONH-, -NHCO-, -NH(C=O)O-, - S-, or -SO₂- (provided that adjacent divalent carbon atoms are not replaced at the same time);
a hydrogen atom in R^{4A}, R^{4B}, R^{4C}, and R^{4D} may be substituted by, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, or (j) a C₁-₁₈ hydrocarbyl group, a C₁-₁₈ hydrocarbyloxy group, a C₁-₁₈ hydrocarbylcarbonyl group, a C₁-₁₈ hydrocarbylcarbonyloxy group, a C₁-₁₈ hydrocarbyloxycarbonyl group, a C₁-₁₈ hydrocarbyloxycarbonyloxy group, or a C₁-₁₈ hydrocarbylthio group, in which at least part of a hydrogen atom may be substituted by (a) to (i), and a divalent carbon atom at any position except the ends of these substituents may be replaced by -O-, -C(=O)-, -C(=O)O-, -OCO-, -CONH-, -NHCO-, -NH(C=O)O-, -S-, or -SO₂- (provided that adjacent divalent carbon atoms are not replaced at the same time); and
furthermore, any two of R^{4A}, R^{4B}, R^{4C}, and R^{4D} may be linked to each other directly by a single bond or via a divalent linking group -O-, -S-, -C(=O)-, -S(=O)-, -S(=O)₂-, - C(=O)O-, or a C₁₋₃ alkylene group to form a ring together with the phosphorus atom in the formula (IV).

R^{4A}, R^{4B}, R^{4C}, and R^{4D} in the formula (IV) preferably each independently denote an optionally substituted C₁-₁₈ hydrocarbyl group, more preferably a C₁₋₁₂ alkyl group, a C₁₋₁₂ alkenyl group, a C₁₋₁₂ alkynyl group, or a C₁₋₁₂ alicyclic group.

Specific examples of the organic phosphonium cation include (methoxymethyl)triphenylphosphonium cation, tetrabutylphosphonium cation, tetraethylphosphonium cation, amyltriphenylphosphonium cation, acetonyltriphenylphosphonium cation, benzyltriphenylphosphonium cation, ethyltriphenylphosphonium cation, butyltriphenylphosphonium cation, hexyltriphenylphosphonium cation, (1-naphthylmethyl)triphenylphosphonium cation, (4-nitrobenzyl)triphenylphosphonium cation, (2-hydroxybenzyl)triphenylphosphonium cation, tetraphenylphosphonium cation, triphenyltetradecylphosphonium cation, cyclopropylphenylphosphonium cation, ethoxycarbonylmethyl(triphenyl)phosphonium cation, phenacyltriphenylphosphonium cation, and the like.

### [1-1-3. Solvate of Polyacid Salt]

The polyacid salt used in the present embodiment is preferably a solvate of the polyacid salt from the perspective of improving the solubility in a solvent.

When the solvent that solvates the polyacid salt include a first solvent that is a good solvent for the polyacid salt, that is, a solvent having a dipole moment (D) per van der Waals volume (Å³) of 0.055 D/Å³ or more and a hydrogen-bonding term (ΔH) in the Hansen solubility parameter of 17 MPa^{1/2} or less, the solubility of the solvate of the polyacid salt in the solvent can be improved.

The solvent that solvates the polyacid salt may further contain a solvent that is a poor solvent for the polyacid salt. The poor solvent may be a solvent having a dipole moment (D) per van der Waals volume (Å³) of less than 0.055 D/Å³ or a hydrogen-bonding term (ΔH) in the Hansen solubility parameter of more than 17 MPa^{1/2}.

### <Dipole Moment per van der Waals Volume>

The term "van der Waals volume", as used herein, refers to the volume of a solvent molecule when atoms constituting the solvent molecule are approximated by a sphere with a van der Waals radius. In the present description, the value of alvaDesc 2.0.12 was used as the van der Waals volume of each solvent molecule.

In this description, the dipole moment of each solvent molecule was calculated using SCIGRESS FQ 3.4.4 manufactured by Fujitsu Ltd.

A dipole moment per van der Waals volume of 0.055 D/Å³ or more means that the structure of the solvent molecule is fixed and the planarity is high, or the solvent molecule has a relatively small size and polarization occurs in the solvent molecule, and it can be said that the solvent molecule can easily solvate a polyacid salt.

### <Hydrogen-Bonding Term (ΔH) in Hansen Solubility Parameter>

The Hansen solubility parameter is expressed in a three-dimensional space by dividing the solubility of a substance into three components: a dispersion term ΔD, a polarity term ΔP, and a hydrogen-bonding term ΔH. The dispersion term ΔD indicates an effect due to dispersion force, the polarity term ΔP indicates an effect due to dipole-dipole force, and the hydrogen-bonding term ΔH indicates an effect due to a hydrogen bond.

The Hansen solubility parameter can be calculated using a known and commonly used method and known and commonly used software. In the present description, ΔH as an estimated value calculated using Hansen Solubility Parameters in Practice (HSPiP) 5th Edition 5.4.02 is used.

When the hydrogen-bonding term ΔH of the Hansen solubility parameter is more than 17 MPa^{1/2}, the energy required to break a hydrogen bond formed between solvent molecules and required for the solvent molecules to solvate a polyacid salt increases, which makes it difficult to become a good solvent for the polyacid salt.

The first solvent to be solvated with the polyacid salt is, for example, one of various solvents listed below in Table 1, and Table 1 shows the van der Waals volume (Å³), the dipole moment (D), the dipole moment per van der Waals volume (D/Å³), the hydrogen-bonding term (ΔH) in the Hansen solubility parameter, and the boiling point (°C at 760 mmHg) of each solvent.

The poor solvent to be solvated with the polyacid salt is, for example, one of various solvents listed below in Table 2, and Table 2 shows the van der Waals volume (Å³), the dipole moment (D), the dipole moment per van der Waals volume (D/Å³), and the hydrogen-bonding term (ΔH) in the Hansen solubility parameter of each solvent.

**[Table 1]**

| No. | Solvent name | CAS No. | van der Waals volume (Å³) | Dipole moment (D) | Dipole moment per van der Waals volume (D/Å³) | ΔH | Boiling point (°C@760 mmHg) |
|---|---|---|---|---|---|---|---|
| 1 | acetylacetone | 123-54-6 | 60.9 | 4.65 | 0.076 | 6.2 | 136 |
| 2 | acetonylacetone | 110-13-4 | 70.5 | 4.65 | 0.066 | 6.1 | 193 |
| 3 | cyclohexanone | 108-94-1 | 62 | 3.64 | 0.059 | 4.6 | 154 |
| 4 | cyclopentanone | 120-92-3 | 52 | 3.41 | 0.066 | 5.1 | 130 |
| 5 | 2-cyclohexen-1-one | 930-68-7 | 59 | 4.63 | 0.078 | 5.2 | 170 |
| 6 | 2-cyyclopenten-1-one | 930-30-3 | 49.5 | 4.11 | 0.083 | 6.2 | 136 |
| 7 | 3-methyl-2-cyclopentenone | 2758-18-1 | 69 | 5.08 | 0.074 | 6.1 | 157 |
| 8 | hydroxyacetone | 116-09-6 | 44.6 | 4.93 | 0.111 | 16.5 | 145 |
| 9 | 4-hydroxy-2-butanone | 590-90-9 | 54.2 | 4.27 | 0.079 | 14.5 | 156 |
| 10 | lactonitrile | 78-97-7 | 44.5 | 3.19 | 0.072 | 16.4 | - |
| 11 | 3-methoxypropionitrile | 110-67-8 | 54 | 3.55 | 0.066 | 7.0 | - |
| 12 | dimethylcyanamide | 1467-79-4 | 47.3 | 5.24 | 0.111 | 6.8 | - |
| 13 | nitromethane | 75-52-5 | 32.2 | 3.98 | 0.124 | 8.1 | - |
| 14 | β-propiolactone | 57-57-8 | 37.2 | 4.41 | 0.119 | 9.5 | - |
| 15 | 1,3,2-dioxathiolane 2-oxide | 3741-38-6 | 45.7 | 2.99 | 0.065 | 6.6 | - |
| 16 | 1-methyl-2-pyrrolidone | 872-50-4 | 59 | 4.46 | 0.076 | 7.4 | 202 |
| 17 | γ-butyrolactone | 96-48-0 | 46.8 | 5.09 | 0.109 | 7.8 | 204 |
| 18 | dimethyl sulfoxide | 67-68-5 | 45.1 | 4.71 | 0.104 | 8.1 | 189 |
| 19 | N,N-dimethylformamide | 68-12-2 | 47.4 | 4.57 | 0.096 | 11.4 | 153 |
| 20 | diacetone alcohol | 123-42-2 | 73.4 | 4.21 | 0.057 | 10.4 | 164 |
| 21 | acetone | 67-64-1 | 40 | 3.52 | 0.088 | 6.5 | 56 |
| 22 | propylene carbonate | 108-32-7 | 50.8 | 5.72 | 0.113 | 4.1 | 240 |
| 23 | acetonitrile | 75-05-8 | 30.9 | 3.83 | 0.124 | 6.1 | 81.6 |
| 24 | ethylene sulfide | 3741-38-6 | 45.7 | 2.99 | 0.065 | 6.6 | 172 |
| 25 | 3-hydroxy-3-methyl-2-butanone | 115-22-0 | 62.8 | 5.10 | 0.081 | 11.3 | 141 |

**[Table 2]**

| No. | Solvent name | CAS No. | van der Waals volume (Å³) | Dipole moment (D) | Dipole moment per van der Waals volume (D/Å³) | ΔH |
|---|---|---|---|---|---|---|
| 26 | benzyl alcohol | 100-51-6 | 65.7 | 1.84 | 0.028 | 12.5 |
| 27 | methyl pyruvate | 600-22-6 | 55.3 | 1.13 | 0.020 | 8.9 |
| 28 | 4-methyl-2-pentanol | 108-11-2 | 72.3 | 2.28 | 0.032 | 9.9 |
| 29 | 4-methyl-2-pentanone | 108-10-1 | 69.4 | 3.34 | 0.048 | 3.9 |
| 30 | ethyl lactate | 97-64-3 | 67.8 | 2.56 | 0.038 | 13.1 |
| 31 | 1-methoxy-2-propanol | 107-98-2 | 57.1 | 2.43 | 0.043 | 12.5 |
| 32 | propylene glycol 1-monomethyl ether 2-acetate | 108-65-6 | 77.4 | 3.99 | 0.052 | 6.6 |
| 33 | 2,6-dimethylpyridine | 108-48-5 | 68.5 | 1.21 | 0.018 | 4.7 |
| 34 | isopropyl alcohol | 67-63-0 | 43.5 | 2.05 | 0.047 | 12.8 |
| 35 | ethanol | 64-17-5 | 34 | 1.91 | 0.056 | 17.2 |
| 36 | acetophenone | 98-86-2 | 72.4 | 3.46 | 0.048 | 4.5 |
| 37 | 2-(hydroxymethyl)furan | 98-00-0 | 53.5 | 1.63 | 0.030 | 14.4 |
| 38 | 1,4-dioxane | 123-91-1 | 49.7 | 0.002 | 0.000 | 8.1 |
| 39 | toluene | 108-88-3 | 61.7 | 0.682 | 0.011 | 3.3 |
| 40 | tert-butyl methyl ether | 1634-04-4 | 72.7 | 1.716 | 0.024 | 3.2 |
| 41 | tetrahydrofuran | 109-99-9 | 45.7 | 2.285 | 0.050 | 5.8 |
| 42 | water | 7732-18-5 | 14.8 | 2.07 | 0.140 | 42.3 |
| 43 | ethylene glycol | 107-21-1 | 37.9 | 0.942 | 0.025 | 27.4 |

The poor solvent used in the present embodiment may be a solvent having a dipole moment (D) per van der Waals volume (Å³) of less than 0.055 D/Å³ or a hydrogen-bonding term (ΔH) in the Hansen solubility parameter of more than 17 MPa^{1/2}, for example, a ketone solvent, an ether solvent, an ester solvent, an alcohol solvent, a hydrocarbon solvent, an aromatic hydrocarbon solvent, a heterocyclic solvent, a halogen solvent, water, or the like satisfying the above requirements.

The ketone solvent that can be used as the poor solvent is, for example, methyl ethyl ketone, 4-methyl-2-pentanone (methyl isobutyl ketone), di-n-butyl ketone, acetophenone, methyl pyruvate, or the like.

The ether solvent that can be used as the poor solvent is, for example, a chain ether, such as 1-methoxy-2-propanol, ethyl ether, isopropyl ether, t-butyl methyl ether, or anisole; a cyclic ether, such as 1,4-dioxane, tetrahydrofuran, or 1,3-dioxolane; or the like.

The ester solvent that can be used as the poor solvent is, for example, ethanol, propylene glycol-1-monomethyl ether-2-acetate, propylene glycol-1-monoethyl ether-2-acetate, propylene glycol-1-monobutyl ether-2-acetate, ethylene glycol diacetate, diethyl oxalate, methyl 3-methoxypropionate, or the like.

The alcohol solvent that can be used as the poor solvent is, for example, isopropyl alcohol, t-butyl alcohol, 4-methyl-pentanol, benzyl alcohol, ethylene glycol, propylene glycol, ethyl lactate, butyl lactate, 2-(hydroxymethyl)furan, or the like.

The hydrocarbon solvent that can be used as the poor solvent is, for example, a chain hydrocarbon solvent, such as n-pentane, n-hexane, n-heptane, or n-octane; a cyclic hydrocarbon solvent, such as cyclopentane, cyclohexane, methylcyclohexane, ethylcyclohexane, butylcyclohexane, cycloheptane, or cyclooctane; or the like.

The aromatic hydrocarbon solvent that can be used as the poor solvent is, for example, benzene, toluene, xylene, ethylbenzene, mesitylene, or the like.

The heterocyclic solvent that can be used as the poor solvent is, for example, pyridine, picoline, 2,6-dimethylpyridine, quinoline, 1-methylpyrrole, 3-methylpyrrole, or the like.

The halogen solvent that can be used as the poor solvent is, for example, dichloromethane, chloroform, 1,2-dichloroethane, chlorobenzene, or the like.

### <Method for Producing Solvate of Polyacid Salt>

The method for producing a solvate of a polyacid salt may be, but is not limited to, a known and commonly used method for producing a solvate.

The step of producing a solvate of a polyacid salt may include (1) a step of dissolving or dispersing the polyacid salt in one or more first solvents that are good solvents for the polyacid salt to prepare a good solvent solution, (2) a step of distilling off the solvent(s) from the good solvent solution at atmospheric pressure or under reduced pressure, (2') a step of cooling the good solvent solution from the temperature at the time of dissolving the polyacid salt, (2") a step of adding a solvent that is a poor solvent for the polyacid salt to the good solvent solution, (2‴) a step of adding the poor solvent to the good solvent solution, then cooling the good solvent solution, and the like, and when a deposit or precipitate forms, (3) a step of filtering off the solid, (4) a step of drying the filtered solid, and the like.

The method for producing a solvate of a polyacid salt according to the present embodiment is, for example, a method for producing a solvate of a polyacid salt including a step of dissolving a polyacid salt in one or more first solvents that are good solvents for the polyacid salt to prepare a good solvent solution.

A method for producing a solvate of a polyacid salt according to another embodiment is, for example, a method for producing a solvate of a polyacid salt including a step of dissolving a polyacid salt in one or more first solvents that are good solvents for the polyacid salt to prepare a good solvent solution and a step of adding a solvent that is a poor solvent for the polyacid salt to the good solvent solution to precipitate a solvate of the polyacid salt.

The solvate of the polyacid salt includes not only a solid (including a powder or the like) or an oily substance deposited or precipitated through these production steps, or a crude, but also the good solvent solution itself, a concentrated product thereof, and a saturated solution thereof, and these may be used as they are.

### [1-1-4. Polyacid Salt Content]

The polyacid salt content of the resist material is not particularly limited and can be appropriately determined according to the method for applying the resist material to a substrate or the like, the coating film thickness, and the like. The polyacid salt content of the resist material preferably ranges from 0.01% to 20% by mass, more preferably 0.1% to 15% by mass.

### [1-2. First Solvent and Second Solvent]

The first solvent according to the present embodiment is a solvent having a dipole moment (D) per van der Waals volume (Å³) of 0.055 D/Å³ or more and a hydrogen-bonding term (ΔH) in the Hansen solubility parameter of 17 MPa^{1/2} or less.

The second solvent according to the present embodiment is a solvent different from the first solvent and is a ketone or alcohol solvent having a surface tension in the range of 20 to 35 dyne/cm and a boiling point of 165°C or less.

The phrase "different from the first solvent", as used herein, means selecting a second solvent that is different in type from the predetermined solvent selected as the first solvent.

### [1-2-1. First Solvent]

The first solvent may be the same solvent as the first solvent that can be used as the solvent that solvates the polyacid salt described in [1-1-3.]. That is, the first solvent, which has the physical properties of a dipole moment (D) per van der Waals volume (Å³) of 0.055 D/Å³ or more and a hydrogen-bonding term (ΔH) in the Hansen solubility parameter of 17 MPa^{1/2} or less, can act as a good solvent for a polyacid salt and can improve the solubility of the polyacid salt in the resist material, thereby providing a resist material that can form a film.

Specific examples of the first solvent include various solvents listed in Table 1 and the like. The first solvent is preferably N,N-dimethylformamide, 2-cyclopenten-1-one, 4-hydroxy-2-butanone, 3-methyl-2-cyclopentenone, acetylacetone, acetonylacetone, 2-cyclohexen-1-one, 1-methyl-2-pyrrolidone, γ-butyrolactone, cyclohexanone, cyclopentanone, diacetone alcohol, hydroxyacetone, 3-methoxypropionitrile, dimethyl cyanamide, lactonitrile, ethylene sulfide, or 3-hydroxy-3-methyl-2-butanone, more preferably N,N-dimethylformamide, 2-cyclopenten-1-one, 4-hydroxy-2-butanone, 3-methyl-2-cyclopentenone, acetylacetone, acetonylacetone, 2-cyclohexen-1-one, 1-methyl-2-pyrrolidone, or γ-butyrolactone, still more preferably N,N-dimethylformamide, 2-cyclopenten-1-one, 4-hydroxy-2-butanone, 3-methyl-2-cyclopentenone, or γ-butyrolactone.

### [1-2-2. Second Solvent]

The second solvent may be a solvent different from the first solvent and may be a ketone or alcohol solvent having a surface tension in the range of 20 to 35 dyne/cm and a boiling point of 165°C or less. A solvent having these physical properties and the like can be used as the second solvent to provide a resist material having film formability.

In the present description, the surface tension of each solvent may be a value registered in the database of The Good Scents Company Information System (http://www.thegoodscentscompany.com).

The second solvent preferably has a surface tension in the range of 20 to 35 dyne/cm, more preferably 22 to 34 dyne/cm. A surface tension much higher than 35 dyne/cm tends to result in a large contact angle at the time of coating due to the high surface tension, aggregation of the resist material in the form of a droplet, a coating film defect, such as cissing or a dent, or poor leveling. On the other hand, a surface tension of the second solvent much lower than 20 dyne/cm unfavorably makes it difficult to uniformly adjust the film thickness in the step of applying the resist material.

The second solvent preferably has a boiling point of 165°C or less, more preferably 160°C or less. A ketone or alcohol solvent having a boiling point of 165°C or less can be used as the second solvent to allow the second solvent to volatilize easily, suppress the occurrence of cissing, and provide a resist material having few film defects after drying.

Specific examples of the second solvent are listed below in Table 3, along with their names, surface tensions (dyne/cm), boiling points, and classifications as ketone or alcohol solvents.

**[Table 3]**

| No. | Solvent name | CAS No. | Surface tension (dyne/cm) | Boiling point (°C@760 mmHg) | Ketone | Alcohol |
|---|---|---|---|---|---|---|
| 1 | acetylacetone | 123-54-6 | 27.5 | 136 | ○ | - |
| 2 | cyclohexanone | 108-94-1 | 32.5 | 154 | ○ | - |
| 3 | cyclopentanone | 120-92-3 | 34.0 | 130 | ○ | - |
| 4 | 3-methyl-2-cyclopentenone | 2758-18-1 | 32.1 | 157 | ○ | - |
| 5 | hydroxyacetone | 116-09-6 | 32.3 | 145 | ○ | ○ |
| 6 | 4-hydroxy-2-butanone | 590-90-9 | 32.5 | 156 | ○ | ○ |
| 7 | diacetone alcohol | 123-42-2 | 30.6 | 164 | ○ | ○ |
| 8 | methyl pyruvate | 600-22-6 | 29.1 | 137 | ○ | - |
| 9 | 4-methyl-2-pentanol | 108-11-2 | 25.3 | 132 | - | ○ |
| 10 | 4-methyl-2-pentanone | 108-10-1 | 22.8 | 116.5 | ○ | - |
| 11 | ethyl lactate | 97-64-3 | 33.2 | 154 | - | ○ |
| 12 | 1-methoxy-2-propanol | 107-98-2 | 26.9 | 119 | - | ○ |
| 13 | isopropyl alcohol | 67-63-0 | 22.6 | 82 | - | ○ |
| 14 | ethanol | 64-17-5 | 22.3 | 78 | - | ○ |
| 15 | 3-methoxy-1-butanol | 2517-43-3 | 27.8 | 159 | - | ○ |

The second solvent is preferably ethyl lactate, diacetone alcohol, 1-methoxy-2-propanol, cyclopentanone, cyclohexanone, methyl pyruvate, 4-methyl-2-pentanol, or 2,6-dimethylpyridine, more preferably ethyl lactate, diacetone alcohol, 1-methoxy-2-propanol, cyclopentanone, cyclohexanone, or 2,6-dimethylpyridine, still more preferably ethyl lactate, diacetone alcohol, 1-methoxy-2-propanol, cyclopentanone, or cyclohexanone.

### [1-2-3. Boiling Point Difference between First Solvent and Second Solvent]

The boiling point difference between the first solvent and the second solvent is preferably, but not limited to, 50°C or less, more preferably 40°C or less, still more preferably 30°C or less. When the boiling point difference between the first solvent and the second solvent is 50°C or less, it is possible to prevent one solvent from being preferentially removed during drying and to form a film having fewer defects.

The combination of the first solvent and the second solvent in which the boiling point difference is 50°C or less may be, for example, but is not limited to, a combination appropriately selected from the first solvents listed in Table 1 and the second solvents listed in Table 3.

### [1-2-4. Content and Content Ratio of Solvent]

The first solvent content and the second solvent content of the resist material are not particularly limited and can be appropriately set according to the type of polyacid salt or solvate thereof to be used, the method for applying the resist material to a substrate or the like, the coating film thickness, and the like.

The first solvent content of the resist material preferably ranges from 1% to 60% by mass, more preferably 3% to 50% by mass, still more preferably 5% to 40% by mass.

The second solvent content of the resist material preferably ranges from 30% to 97% by mass, more preferably 40% to 95% by mass, still more preferably 50% to 92% by mass.

The mass ratio of the first solvent to the second solvent in the resist material is not particularly limited and can be appropriately set according to the type of polyacid salt or solvate thereof to be used, the method for applying the resist material to a substrate or the like, the coating film thickness, and the like.

The mass ratio of the first solvent to the second solvent is preferably 0.5 to 6:4 to 9.5, more preferably 1 to 5:5 to 9, still more preferably 1 to 4:6 to 9.

### [1-3. Others]

If desired, the resist material according to the present embodiment can appropriately contain, as a miscible additive agent, for example, an additional resin for improving the performance of a resist film, a dissolution inhibitor, a plasticizer, a stabilizer, a colorant, an antihalation agent, a dye, or the like.

The resist material according to the present embodiment preferably does not contain an epoxy resin. Furthermore, hydrogen peroxide is also preferably not contained.

### [2. Method for Producing Resist Material]

The method for producing a resist material according to the present embodiment may be, but is not limited to, a known and commonly used method. The method for producing a resist material is, for example, a method for dissolving a polyacid salt in a mixed solvent of the first solvent and the second solvent to prepare the resist material, or the like.

Here, by dissolving a polyacid salt in advance in one or more first solvents that are good solvents for the polyacid salt, bringing the polyacid salt into a state of being solvated with the first solvent(s), and then adding the second solvent thereto, the polyacid salt can be dissolved at a higher concentration as compared with the case where the polyacid salt itself is directly dissolved in a mixed solvent of the first solvent and the second solvent.

Furthermore, a polyacid salt can be dissolved at a higher concentration by, for example, precipitating a solvate of the polyacid salt through a step of dissolving the polyacid salt in one or more first solvents that are good solvents for the polyacid salt to prepare a good solvent solution, and sequentially dissolving the solvate of the polyacid salt in the first solvent and the second solvent or dissolving the solvate of the polyacid salt in a mixed solvent of the first solvent and the second solvent.

A solvate of a polyacid salt in a solid state (including a powder, a crystal, or the like) precipitated through a step of dissolving the polyacid salt in one or more first solvents that are good solvents for the polyacid salt to prepare a good solvent solution and a step of adding a solvent that is a poor solvent for the polyacid salt to the good solvent solution to precipitate the solvate of the polyacid salt may be sequentially or simultaneously dissolved in the first solvent and the second solvent.

### [3. Film Forming Method]

A film forming method according to the present embodiment includes a step of applying a resist material to a substrate.

The "substrate" and the "coating method" will be described below.

### <Substrate>

The substrate used in the present embodiment is not particularly limited and can be a known and commonly used substrate. The substrate is, for example, a substrate for an electronic component, a substrate on which a predetermined wiring pattern is formed, or the like.

The material of the substrate is, for example, but not limited to, a silicon wafer, a substrate made of a metal, such as copper, chromium, iron, or aluminum, a substrate made of an inorganic substance, such as glass, titanium oxide, or silicon dioxide, or the like.

The substrate may have any size, shape, and the like, may have a smooth, curved, or rough surface, and may be a flaky substrate or the like.

The surface of the substrate may be subjected to a surface treatment as necessary. In the case of a substrate having a hydroxy group on a surface layer thereof, the surface of the substrate may be treated with a silane coupling agent capable of reacting with the hydroxy group to change the surface layer of the substrate from hydrophilic to hydrophobic, thereby enhancing the adhesion between the substrate and a film containing a metal compound. The silane coupling agent is, for example, hexamethyldisilazane (HMDS) or the like.

### <Application Method>

The method for applying the resist material to a substrate is not particularly limited and can be a known and commonly used method. The application method includes a dry method, for example, a chemical vapor deposition (CVD) method, such as thermal CVD, plasma CVD, or photo-CVD; a physical vapor deposition (PVD) method, such as vacuum deposition, plasma-assisted vapor deposition, sputtering, or ion plating; or the like. A wet method, for example, a coating method, such as spin coating, bar coating, roll coating, flow coating, dip coating, spray coating, ink jet printing, or screen printing, can also be used.

From the perspective of forming a film with a uniform thickness or the like, the method for applying the resist material according to the present embodiment to a substrate is preferably a wet method, such as a spin coating method or screen printing, more preferably a spin coating method. After the coating film is formed, a backside rinse step, an edge bead removal step, or the like may be performed to remove an edge bead.

A resist film formed by applying the resist material to a substrate may be dried by any method, for example, using a heater (post-apply bake (PAB)), such as a hot plate, or a pressure reduction apparatus.

The baking conditions are not particularly limited and can be appropriately determined according to the type, application, and the like of the resist film. The baking temperature preferably ranges from 80°C to 300°C, more preferably 150°C to 250°C, still more preferably 170°C to 230°C. The baking time preferably ranges from 10 seconds to 300 seconds, more preferably 20 seconds to 180 seconds, still more preferably 30 seconds to 120 seconds.

The thickness of the resist film after drying is preferably, but not limited to, in the range of 0.5 to 100 nm, more preferably 1 to 75 nm, still more preferably 1 to 60 nm.

### EXAMPLES

The present invention will be more specifically described below with reference to examples, but the present invention is not limited to these examples.

### [1. Synthesis of Polyacid Salt]

Polyacid salts 1 to 7 were synthesized by the following methods.

### <Polyacid salt 1: hexakis(phenylbis(2-(trifluoromethyl)phenyl)sulfonium)metatungstate>

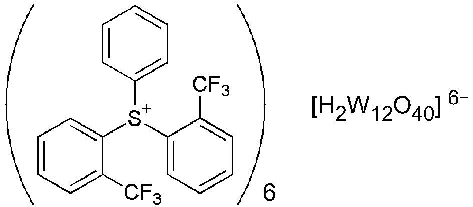

6.68 g of phenylbis(2-(trifluoromethyl)phenyl)sulfonium chloride was dissolved in 99.36 g of pure water, 6.88 g of ammonium metatungstate (manufactured by Nippon Inorganic Colour & Chemical Co., Ltd.: ammonium metatungstate hydrate ((NH₄)₆[H₂W₁₂O₄₀]·xH₂O)) was added thereto, and the reaction liquid was stirred at room temperature for 30 minutes. A powder produced by filtering the reaction liquid was dried under reduced pressure at room temperature for 18 hours. The dried powder was dissolved in 100 g of dimethylformamide, 335 g of methanol was then added thereto, and a target compound (polyacid salt 1) was produced by crystallization at room temperature.

¹H-NMR (400MHz, DMSO-D6): δ (ppm) = 8.35-7.65 (m, 13H), 5.97 (s, 0.33H).

¹⁸³W-NMR (20.84MHz, DMSO-D6): δ(ppm) = -100.13 (s, 12W).

ESI-MS: POSITIVE m/z 399.1 ([C₂₀H₁₃F₆S]⁺)
NEGATIVE m/z 712.3 (median) ([H₄W₁₂O₄₀]⁴⁻)

### <Polyacid salt 2: metatungstate containing five phenylbis(2-(trifluoromethyl)phenyl)sulfonium (the following compound)>

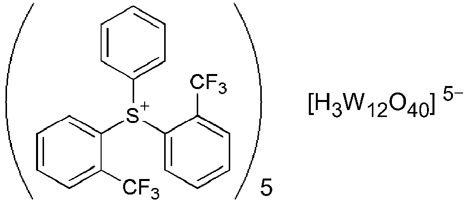

100 g of 0.1 mol/L aqueous hydrochloric acid were added to 16.67 g of ammonium metatungstate (manufactured by Nippon Inorganic Colour & Chemical Co., Ltd.: ammonium metatungstate hydrate ((NH₄)₆[H₂W₁₂O₄₀]_{·}xH₂O) and were stirred at room temperature for 60 minutes. An aqueous solution of 13.47 g of phenyl bis(2-(trifluoromethyl)phenyl)sulfonium chloride in 200 g of pure water was then added to this reaction liquid and was stirred at room temperature for 30 minutes. A powder prepared by filtering the reaction liquid was dried under reduced pressure at room temperature for 18 hours. The dried powder was dissolved in 100 g of dimethylformamide, 335 g of methanol was then added thereto, and a target compound (polyacid salt 2) was produced by crystallization at room temperature.

¹H-NMR (400MHz, DMSO-D6): δ (ppm) = 8.35-7.65 (m, 13H), 6.77 (s, 0.60H).

¹⁸³W-NMR (20.84MHz, DMSO-D6): δ(ppm) = -87.59 (s, 12W).

ESI-MS: POSITIVE m/z 399.1 ([C₂₀H₁₃F₆S]⁺)
NEGATIVE m/z 712.3 (median) ([H₄W₁₂O₄₀]⁴⁻)

### <Polyacid salt 3: tetrakis(phenylbis(2-(trifluoromethyl)phenyl)sulfonium)silicotungstate>

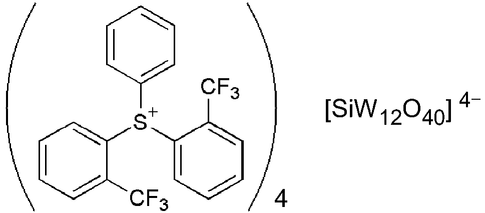

37.26 g of phenylbis(2-(trifluoromethyl)phenyl)sulfonium chloride was dissolved in 50 g of cyclohexanone, 41.06 g of silicotungstic acid (H₄[SiW₁₂O₄₀]·26H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a target compound (polyacid salt 3).

¹H-NMR (400MHz, DMSO-D6): δ (ppm) = 8.34-7.63 (m, 52H).

¹⁸³W-NMR (20.84MHz, DMSO-D6): δ (ppm) = -92.7 (s, 12W).

ESI-MS: NEGATIVE m/z 718.5 (median) ([SiW₁₂O₄₀]⁴⁻)
XPS analysis S:W (the mole ratio of S to W) = 4:12

### <Polyacid salt 4: tris(phenylbis(2-(trifluoromethyl)phenyl)sulfonium)phosphotungstate>

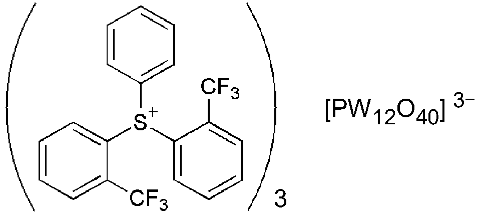

A target compound (polyacid salt 4) was produced in the same manner as in the method for synthesizing the polyacid salt 3 except that, as raw material compounds, 37.26 g of phenylbis(2-(trifluoromethyl)phenyl)sulfonium chloride was changed to 27.95 g and the silicotungstic acid was replaced by 41.97 g of phosphotungstic acid (H₃[PW₁₂O₄₀]·30H₂O).

¹H-NMR (400MHz, DMSO-D6): δ (ppm) = 8.36-7.63 (m, 39H).

¹⁸³W-NMR (20.84MHz, DMSO-D6): δ (ppm) = -86.7 (s, 12W).

ESI-MS: NEGATIVE m/z 959 (median) ([PW₁₂O₄₀]³⁻)
XPS analysis S:W (the mole ratio of S to W) = 3:12

### <Polyacid salt 5: tris((2-hydroxyethyl)trimethylammonium)phosphotungstate>

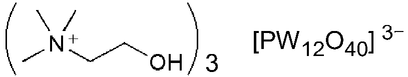

A target compound (polyacid salt 5) was produced in the same manner as in the method for synthesizing the polyacid salt 3 except that, as raw material compounds, phenylbis(2-(trifluoromethyl)phenyl)sulfonium chloride was replaced by 0.2 g of (2-hydroxyethyl)trimethylammonium chloride and the silicotungstic acid was replaced by 1.0 g of phosphotungstic acid (H₃[PW₁₂O₄₀]·30H₂O).

¹H-NMR (400MHz, DMSO-D6): δ (ppm) = 5.28(br, 3H), 3.84(m, 6H), 3.40(m, 6H), 3.11 (s, 27H).

¹⁸³W-NMR (20.84MHz, DMSO-D6): δ (ppm) = -86.7(s, 12W).

ESI-MS: NEGATIVE m/z 959 (median) ([PW₁₂O₄₀]³⁻)
XPS analysis N:W (the mole ratio of N to W) = 3:12

### <Polyacid salt 6: tris(tetrahexylammonium)phosphotungstate)>

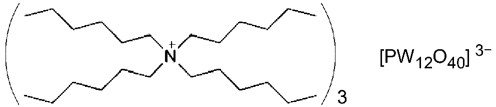

A target compound (polyacid salt 6) was produced in the same manner as in the method for synthesizing the polyacid salt 3 except that, as raw material compounds, phenylbis(2-(trifluoromethyl)phenyl)sulfonium chloride was replaced by 0.5 g of tetrahexylammonium iodide and the silicotungstic acid was replaced by 1.0 g of phosphotungstic acid (H₃[PW₁₂O₄₀]·30H₂O).

¹H-NMR (400MHz, DMSO-D6): δ (ppm)=3.16 (m, 24H), 1.57 (m, 24H), 1.30 (s, 72H), 0.88 (t, 36H).

¹⁸³W-NMR (20.84MHz, DMSO-D6): δ (ppm) = -86.7 (s, 12W).

ESI-MS: NEGATIVE m/z 959 (median) ([PW₁₂O₄₀]³⁻)
XPS analysis N:W (the mole ratio of N to W) = 3:12

### <Polyacid salt 7: tris(tetraphenylphosphonium)phosphotungstate>

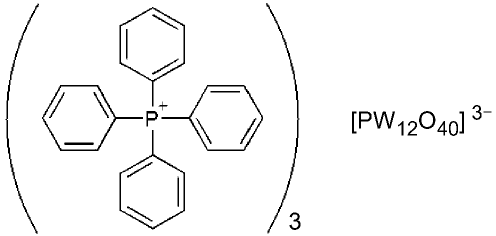

A target compound (polyacid salt 7) was produced in the same manner as in the method for synthesizing the polyacid salt 3 except that, as raw material compounds, phenylbis(2-(trifluoromethyl)phenyl)sulfonium chloride was replaced by 0.45 g of tetraphenylphosphonium chloride and the silicotungstic acid was replaced by 1.0 g of phosphotungstic acid (H₃[PW₁₂O₄₀]·30H₂O).

¹H-NMR (400MHz, DMSO-D6): δ (ppm) = 8.05-7.65 (m, 60H).

¹⁸³W-NMR (20.84MHz, DMSO-D6): δ (ppm) = -86.7(s, 12W).

ESI-MS: NEGATIVE m/z 959 (median) ([PW₁₂O₄₀]³⁻)
XPS analysis P:W(the mole ratio of P to W) = 4:12

### [2. Synthesis of Solvate of Polyacid Salt]

As solvates of the polyacid salts 1 to 4, solvates 1 to 12 of polyacid salts were synthesized by the following methods.

### <Solvate 1 of polyacid salt: solvate of hexakis(phenylbis(2-(trifluoromethyl)phenyl)sulfonium)metatungstate solvated with 4-hydroxy-2-butanone and t-butyl methyl ether>

10 g of the polyacid salt 1 (hexakis(phenylbis(2-(trifluoromethyl)phenyl)sulfonium)metatungstate) was dissolved in 100 g of 4-hydroxy-2-butanone. 1000 g of t-butyl methyl ether was added thereto and was stirred for 5 minutes. The resulting precipitate was filtered off with suction and was dried under reduced pressure for 10 minutes.

¹H-NMR (400MHz, DMSO-D6): δ (ppm) = 8.40-7.60 (m, 13H), 5.97 (s, 0.31H), 4.55 (br, 0.026H), 3.63 (m, 0.051H), 3.08 (s, 0.014H), 2.53 (m, 0.051H), 2.09 (s, 0.077H), 1.11 (s, 0.042H).

### <Solvate 2 of polyacid salt: solvate of hexakis(phenylbis(2-(trifluoromethyl)phenyl)sulfonium)metatungstate solvated with 2-cyclopenten-1-one, t-butyl methyl ether, and p-menthane>

2 g of the polyacid salt 1 (hexakis(phenylbis(2-(trifluoromethyl)phenyl)sulfonium)metatungstate) was dissolved in 8 g of 2-cyclopenten-1-one to prepare a 20% by weight solution. 60 g of p-menthane and 100 g of t-butyl methyl ether were added thereto in this order. The resulting precipitate was filtered off with suction and was dried under reduced pressure for 10 minutes.

¹H-NMR (400MHz, DMSO-D6): δ (ppm) = 8.40-7.60 (m, 80H), 6.0 (s, 2H), 3.08 (s, 3H), 2.65 (m, 4H), 2.25 (m, 4.0H), 1.11 (s, 9.0H), 0.09-0.08 (m, 5.2H).

### <Solvate 3 of polyacid salt: solvate of polyacid salt 2 solvated with 4-hydroxy-2-butanone and t-butyl methyl ether>

10 g of the synthesized polyacid salt 2 was weighed and dissolved in 90 g of 4-hydroxy-2-butanone. 1000 g of t-butyl methyl ether was added thereto and was stirred for 5 minutes. The resulting precipitate was filtered off with suction and was dried under reduced pressure for 10 minutes.

¹H-NMR (400MHz, DMSO-D6): δ (ppm) = 8.40-7.60 (m, 65H), 6.71 (s, 3H), 4.55 (br, 3H), 3.63 (t, 5.1H), 3.08 (s, 1.2H), 2.53 (m, 4.9H), 2.09 (s, 7.0H), 1.11 (s, 4H).

### <Solvate 4 of polyacid salt: solvate of polyacid salt 2 solvated with 2-cyclopenten-1-one, p-menthane, and t-butyl methyl ether>

2 g of the synthesized polyacid salt 2 was weighed and dissolved in 8 g of 2-cyclopenten-1-one. 60 g of p-menthane and 600 g of t-butyl methyl ether were added thereto in this order. The resulting precipitate was filtered off with suction and was dried for 10 minutes.

¹H-NMR (400MHz, DMSO-D6): δ (ppm) = 8.40-7.60 (m, 67H), 6.71 (s, 3H), 6.17 (s, 2H), 3.08 (s, 2H), 2.65 (m, 4H), 2.25 (m, 4.0H), 1.11(s, 6.0H), 0.08-0.09 (m, 4.7H).

### <Solvate 5 of polyacid salt: solvate of tetrakis(phenylbis(2-(trifluoromethyl)phenyl)sulfonium)silicotungstate solvated with 4-hydroxy-2-butanone>

2 g of the polyacid salt 3 (tetrakis(phenylbis(2-(trifluoromethyl)phenyl)sulfonium)silicotungstate) was dissolved in 8 g of 4-hydroxy-2-butanone to prepare a 20% by weight solution. 1000 g of t-butyl methyl ether was added thereto. The resulting precipitate was filtered off with suction and was dried under reduced pressure for 10 minutes.

¹H-NMR (400MHz, DMSO-D6): δ (ppm) = 8.40-7.60 (m, 1H), 4.55 (br, 0.038H), 3.63 (m, 0.077H), 2.53 (m, 0.077H), 2.09 (s, 0.12H).

### <Solvate 6 of polyacid salt: solvate of tetrakis(phenylbis(2-(trifluoromethyl)phenyl)sulfonium)silicotungstate solvated with 2-cyclopenten-1-one>

2 g of the polyacid salt 3 (tetrakis(phenylbis(2-(trifluoromethyl)phenyl)sulfonium)silicotungstate) was dissolved in 8 g of 2-cyclopenten-1-one to prepare a 20% by weight solution. 1000 g of t-butyl methyl ether was added thereto. The resulting precipitate was filtered off with suction and was dried under reduced pressure for 10 minutes.

¹H-NMR (400MHz, DMSO-D6): δ (ppm) = 8.40-7.60 (m, 1H), 6.17 (s, 0.038H), 2.65 (m, 0.077H), 2.25 (m, 0.077H).

### <Solvate 7 of polyacid salt: solvate of tris(phenylbis(2-(trifluoromethyl)phenyl)sulfonium)phosphotungstate solvated with 4-hydroxy-2-butanone>

2 g of the polyacid salt 4 (tris(phenylbis(2-(trifluoromethyl)phenyl)sulfonium)phosphotungstate) was dissolved in 8 g of 4-hydroxy-2-butanone to prepare a 20% by weight solution. 1000 g of t-butyl methyl ether was added thereto. The resulting precipitate was filtered off with suction and was dried under reduced pressure for 10 minutes.

¹H-NMR (400MHz, DMSO-D6): δ (ppm) = 8.40-7.60 (m, 1H), 4.55 (br, 0.05H), 3.63 (t, 0.1H), 2.53 (m, 0.1H), 2.09 (s, 0.15H).

### <Solvate 8 of polyacid salt: solvate of tris(phenylbis(2-(trifluoromethyl)phenyl)sulfonium)phosphotungstate solvated with 2-cyclopenten-1-one>

2 g of the polyacid salt 4 (tris(phenylbis(2-(trifluoromethyl)phenyl)sulfonium)phosphotungstate) was dissolved in 18 g of 2-cyclopenten-1-one to prepare a 10% by weight solution. 100 g of p-menthane and 100 g of t-butyl methyl ether were added thereto in this order. The resulting precipitate was filtered off with suction and was dried under reduced pressure for 10 minutes.

¹H-NMR (400MHz, DMSO-D6): δ (ppm) = 8.40-7.60 (m, 1H), 6.17 (s, 0.05H), 2.65 (m, 1.0H), 2.25 (m, 1.0H).

### <Solvate 9 of polyacid salt: solvate of tris(phenylbis(2-(trifluoromethyl)phenyl)sulfonium)phosphotungstate solvated with cyclohexanone and p-menthane>

2 g of the polyacid salt 4 (tris(phenylbis(2-(trifluoromethyl)phenyl)sulfonium)phosphotungstate) was dissolved in 18 g of cyclohexanone to prepare a 10% by weight solution. 200 g of p-menthane and 200 g of t-butyl methyl ether were added thereto in this order. The resulting precipitate was filtered off with suction and was dried under reduced pressure for 10 minutes.

¹H-NMR (400MHz, DMSO-D6): δ (ppm) = 8.40-7.60 (m, 1H), 2.25 (m, 0.06H), 1.77 (m, 0.06H), 1.66 (m, 0.03H), 1.50-1.2 (m, 0.04H), 1.0-0.8 (m, 0.08H).

### <Solvate 10 of Polyacid Salt: solvate of tetrakis(phenylbis(2-(trifluoromethyl)phenyl)sulfonium)silicotungstate solvated with 2-cyclopenten-1-one>

2 g of the polyacid salt 3 (tetrakis(phenylbis(2-(trifluoromethyl)phenyl)sulfonium)silicotungstate) was dissolved in 18 g of 2-cyclopenten-1-one to prepare a 10% by weight solution. Vacuum distillation was performed until the polyacid salt 3 content of the 10% by weight solution reached 50% by weight to prepare a 50% by weight solution.

¹H-NMR (400MHz, DMSO-D6): δ (ppm) = 8.40-7.60 (m, 52H), 6.17 (s, 54H), 2.65 (m, 109H), 2.25 (m, 109H).

### <Solvate 11 of Polyacid Salt: solvate of tetrakis(phenylbis(2-(trifluoromethyl)phenyl)sulfonium)silicotungstate solvated with 4-hydroxy-2-butanone>

2 g of the polyacid salt 3 (tetrakis(phenylbis(2-(trifluoromethyl)phenyl)sulfonium)silicotungstate) was dissolved in 18 g of 4-hydroxy-2-butanone to prepare a 10% by weight solution. Vacuum distillation was performed until the polyacid salt 3 content of the 10% by weight solution reached 50% by weight to prepare a 50% by weight solution.

¹H-NMR (400MHz, DMSO-D6): δ (ppm) = 8.40-7.60 (m, 52H), 4.51 (s, 51H), 3.63 (m, 101H), 2.51 (m, 101H), 2.10 (m, 152H).

### <Solvate 12 of Polyacid Salt: solvate of tetrakis(phenylbis(2-(trifluoromethyl)phenyl)sulfonium)silicotungstate solvated with γ-butyrolactone>

2 g of the polyacid salt 3 (tetrakis(phenylbis(2-(trifluoromethyl)phenyl)sulfonium)silicotungstate) was dissolved in 18 g of γ-butyrolactone to prepare a 10% by weight solution. Vacuum distillation was performed until the polyacid salt 3 content of the 10% by weight solution reached 50% by weight to prepare a 50% by weight solution.

¹H-NMR (400MHz, DMSO-D6): δ (ppm) = 8.40-7.60 (m, 52H), 4.26 (m, 104H), 2.4 (m, 104H), 2.12 (m, 104H).

### [3. Solubility Test and Evaluation]

The solvates 1 to 9 of the polyacid salts synthesized above were tested for their solubility in various solvents listed in Table 4 by the following method.

First, 1 g of each of the powders of the solvates 1 to 9 of the polyacid salts was weighed into beakers. The solvent listed in Table 4 was then added thereto, the mass concentration (% by weight) was calculated from the addition amount of the solvent at the time when dissolution was visually confirmed, and the solubility was evaluated according to the following criteria. Table 4 shows the results.
A: dissolved at 1% by weight or more
B: dissolved at 0.1% by weight or more and less than 1% by weight
C: not dissolved at less than 0.1% by weight

As described above, it was visually confirmed that the polyacid salt 3 was dissolved in 2-cyclopenten-1-one, 4-hydroxy-2-butanone, and γ-butyrolactone in an amount of 50% by weight or more, and this corresponds to A in the evaluation criteria for solubility described above.

**[Table 4]**

| No . | Solvent name | CAS No. | Solvat e 1 of polyac id salt | Solvat e 2 of polyac id salt | Solvat e 3 of polyac id salt | Solvat e 4 of polyac id salt | Solvat e 5 of polyac id salt | Solvat e 6 of polyac id salt | Solvat e 7 of polyac id salt | Solvat e 8 of polyac id salt | Solvat e 9 of polyac id salt |
|---|---|---|---|---|---|---|---|---|---|---|---|
| 1 | acetylacetone | 123-54-6 | B | B | A | A | A | B | B | A | A |
| 2 | acetonylacetone | 110-13-4 | B | B | A | A | A | A | A | A | A |
| 3 | cyclohexanone | 108-94-1 | B | B | A | A | A | A | A | A | A |
| 4 | cyclopentanone | 120-92-3 | B | B | A | A | A | B | A | A | A |
| 5 | 2-cyclohexen-1-one | 930-68-7 | B | B | A | A | A | A | A | A | A |
| 6 | 2-cyclopenten-1-one | 930-30-3 | A | A | A | A | A | A | A | A | A |
| 7 | 3-methyl-2-cyclopentenone | 2758-18-1 | B | B | A | A | A | A | A | A | A |
| 8 | hydroxyacetone | 116-09-6 | A | B | A | B | B | A | A | B | A |
| 9 | 4-hydroxy-2-butanone | 590-90-9 | A | A | A | A | A | A | A | B | A |
| 10 | lactonitrile | 78-97-7 | A | A | A | A | B | B | A | B | A |
| 11 | 3-methoxypropionitrile | 110-67-8 | A | A | A | A | A | A | A | A | A |
| 12 | dimethylcyanamide | 1467-79-4 | A | A | A | A | A | A | A | A | A |
| 13 | nitromethane | 75-52-5 | A | A | A | A | B | B | A | B | A |
| 14 | β-propiolactone | 57-57-8 | A | A | A | A | A | A | A | A | A |
| 15 | 1,3,2-dioxathiolane 2-oxide | 3741-38-6 | A | A | A | A | A | A | A | A | A |
| 16 | 1-methyl-2-pyrrolidone | 872-50-4 | A | A | A | A | A | A | A | A | A |
| 17 | γ-butyrolactone | 96-48-0 | A | A | A | A | A | A | A | A | A |
| 18 | dimethyl sulfoxide | 67-68-5 | A | A | A | A | A | A | A | A | A |
| 19 | dimethylformamide | 68-12-2 | A | A | A | A | A | A | A | A | A |
| 20 | diacetone alcohol | 123-42-2 | B | B | A | B | B | A | A | A | A |
| 21 | acetone | 67-64-1 | B | B | A | A | B | B | A | A | A |
| 22 | propylene carbonate | 108-32-7 | A | A | A | A | A | A | A | A | A |
| 23 | acetonitrile | 75-05-8 | A | A | A | A | B | B | A | A | A |
| 24 | benzyl alcohol | 100-51-6 | A | A | A | C | C | - | C | - | C |
| 25 | methyl pyruvate | 600-22-6 | C | C | C | C | C | C | C | C | C |
| 26 | 4-methyl-2-pentanol | 108-11-2 | C | C | C | C | C | C | C | C | C |
| 27 | 4-methyl-2-pentanone | 108-10-1 | C | C | C | C | C | C | C | C | C |
| 28 | ethyl lactate | 97-64-3 | C | C | C | C | C | C | C | C | C |
| 29 | 1-methoxy-2-propanol | 107-98-2 | C | C | C | C | C | C | C | C | C |
| 30 | propylene glycol 1-monomethyl ether 2-acetate | 108-65-6 | C | C | C | C | C | C | C | C | C |
| 31 | 2,6-dimethylpyridine | 108-48-5 | C | C | C | C | C | C | C | C | C |
| 32 | isopropyl alcohol | 67-63-0 | C | C | C | C | C | C | C | C | C |
| 33 | ethanol | 64-17-5 | C | C | C | C | C | C | C | C | C |
| 34 | acetophenone | 98-86-2 | C | C | C | C | C | C | C | C | C |
| 35 | 2 (hydroxymethyl)furan | 98-00-0 | C | C | C | C | C | C | C | | C |
| 36 | 1,4-dioxane | 123-91-1 | C | C | C | C | C | C | C | C | C |
| 37 | toluene | 108-88-3 | C | C | C | C | C | C | C | C | C |
| 38 | tert-butyl methyl ether | 1634-04-4 | C | C | C | C | C | C | C | C | C |
| 39 | tetrahydrofuran | 109-99-9 | C | C | C | C | C | C | C | C | C |
| 40 | water | 7732-18-5 | C | C | C | C | C | C | C | C | C |
| 41 | ethylene glycol | 107-21-1 | C | C | C | C | C | C | C | C | C |

The solvents of Nos. 1 to 23 listed in Table 4 correspond to the first solvents of Nos. 1 to 23 exemplified in Table 1 as solvents having a dipole moment (D) per van der Waals volume (Å³) of 0.055 D/Å³ or more and a hydrogen-bonding term (ΔH) in the Hansen solubility parameter of 17 or less.

As can be seen from Table 4, all of the solvates 1 to 9 of the polyacid salts exhibited a certain degree of solubility in the first solvents having the above physical properties and were evaluated as A or B in the solubility evaluation. On the other hand, the solvates 1 to 9 of the polyacid salts were not satisfactorily dissolved in the solvents of Nos. 25 to 41, which are solvents other than the first solvents, and were evaluated as C in the solubility evaluation. Furthermore, although the solvates 1 to 3 of the polyacid salts were satisfactorily dissolved in the solvent No. 24, the solvates 4, 5, 7 and 9 of the polyacid salts were not satisfactorily dissolved in the solvent No. 24 and were evaluated as C in the solubility evaluation.

### [4. Film Formability Test and Evaluation (Single Solvent)]

The solvates 1 to 9 of the polyacid salts were dissolved in various solvents listed in Table 5 to prepare resist materials in which the solvates of the polyacid salts were present at 1% by weight.

Each resist material was applied to an 8-inch silicon substrate using a spinner, was then prebaked (PAB) on a hot plate at a temperature of 200°C for 60 seconds, and was dried to form a film, which was then evaluated for film formability.
A: a film could be formed without defects
B: a film could be formed although there were some defects
C: a film could not be formed due to defects over the entire surface

Furthermore, with respect to the solvates 10 to 12 of the polyacid salts, resist materials were prepared in the same manner as described above by dissolving the solvates of the polyacid salts in various solvents listed in Table 5 such that the solvates of the polyacid salts were present at 1% by weight. The same test as described above was then performed to evaluate the film formability according to the evaluation criteria described above, and the results of C were obtained in all cases (not shown in Table 5).

**[Table 5]**

| No . | Solvent name | CAS No. | Solvat e 1 of polyac id salt | Solvat e 2 of polyac id salt | Solvat e 3 of polyac id salt | Solvat e 4 of polyac id salt | Solvat e 5 of polyac id salt | Solvat e 6 of polyac id salt | Solvat e 7 of polyac id salt | Solvat e 8 of polyac id salt | Solvat e 9 of polyac id salt |
|---|---|---|---|---|---|---|---|---|---|---|---|
| 1 | acetylacetone | 123-54-6 | C | C | C | C | C | c | C | C | C |
| 2 | acetonylacetone | 110-13-4 | C | C | C | C | C | c | C | C | C |
| 3 | cyclohexanone | 108-94-1 | C | C | C | C | C | c | C | C | C |
| 4 | cyclopentanone | 120-92-3 | C | C | C | C | C | c | C | C | C |
| 5 | 2-cyclohexen-l-one | 930-68-7 | C | C | C | C | C | C | C | C | C |
| 6 | 2-cyclopenten-l-one | 930-30-3 | C | C | C | C | C | C | C | C | C |
| 7 | 3-methyl-2-cyclopentenone | 2758-18-1 | C | C | C | C | C | C | C | C | C |
| 8 | hydroxyacetone | 116-09-6 | C | C | C | C | C | C | C | C | C |
| 9 | 4-hydroxy-2-butanone | 590-90-9 | C | C | C | C | C | C | C | C | C |
| 10 | lactonitrile | 78-97-7 | C | C | C | C | C | C | C | C | C |
| 11 | 3-methoxypropionitrile | 110-67-8 | C | C | C | C | C | C | C | C | C |
| 12 | dimethylcyanamide | 1467-79-4 | C | C | C | C | C | C | C | C | C |
| 13 | nitromethane | 75-52-5 | C | C | C | C | C | C | C | C | C |
| 14 | β-propiolactone | 57-57-8 | C | C | C | C | C | C | C | C | C |
| 15 | 1,3,2-dioxathiolane 2-oxide | 3741-38-6 | C | C | C | C | C | C | C | C | C |
| 16 | 1-methyl-2-pyrrolidone | 872-50-4 | C | C | C | C | C | C | C | C | C |
| 17 | γ-butyrolactone | 96-48-0 | C | C | C | C | C | C | C | C | C |
| 18 | dimethyl sulfoxide | 67-68-5 | C | C | C | C | C | C | C | C | C |
| 19 | dimethylformamide | 68-12-2 | C | C | C | C | C | C | C | C | C |
| 20 | diacetone alcohol | 123-42-2 | C | C | C | C | C | C | C | C | C |
| 21 | acetone | 67-64-1 | C | C | C | C | C | C | C | C | C |
| 22 | propylene carbonate | 108-32-7 | C | C | C | C | C | C | C | C | C |
| 23 | acetonitrile | 75-05-8 | C | C | C | C | C | C | C | C | C |
| 24 | benzyl alcohol | 100-51-6 | C | C | C | C | C | C | C | C | C |
| 25 | methyl pyruvate | 600-22-6 | C | C | C | C | C | C | C | C | C |
| 26 | 4-methyl-2-pentanol | 108-11-2 | C | C | C | C | C | C | C | C | C |
| 27 | 4-methyl-2-pentanone | 108-10-1 | C | C | C | C | C | C | C | C | C |
| 28 | ethyl lactate | 97-64-3 | C | C | C | C | C | C | C | C | C |
| 29 | 1-methoxy-2-propanol | 107-98-2 | C | C | C | C | C | C | C | C | C |
| 30 | propylene glycol 1-monomethyl ether 2-acetate | 108-65-6 | C | C | C | C | C | C | C | C | C |
| 31 | 2,6-dimethylpyridine | 108-48-5 | C | C | C | C | C | C | C | C | C |
| 32 | isopropyl alcohol | 67-63-0 | C | C | C | C | C | C | C | C | C |
| 33 | ethanol | 64-17-5 | C | C | C | C | C | C | C | C | C |
| 34 | acetophenone | 98-86-2 | C | C | C | C | C | C | C | C | C |
| 35 | 2-(hydroxymethyl)furan | 98-00-0 | C | C | C | C | C | C | C | C | C |
| 36 | 1,4-dioxane | 123-91-1 | C | C | C | C | C | C | C | C | C |
| 37 | toluene | 108-88-3 | C | C | C | C | C | C | C | C | C |
| 38 | tert-butyl methyl ether | 1634-04-4 | C | C | C | C | C | C | C | C | C |
| 39 | tetrahydrofuran | 109-99-9 | C | C | C | C | C | C | C | C | C |
| 40 | water | 7732-18-5 | C | C | C | C | C | C | C | C | C |
| 41 | ethylene glycol | 107-21-1 | C | C | C | C | C | C | C | C | C |

In the resist materials using the solvents of Nos. 24 to 41 in Table 5, defects were observed over the entire surface of the film due to the reason that the solubility of the solvates of the polyacid salts was not good or the like, and the evaluation of the film formability was C.

Furthermore, in the resist materials using the solvents of Nos. 1 to 23 in Table 5, although the solubility of the solvates of the polyacid salts was not poor, the film formability was evaluated as C due to excessively high surface tension of the solvents, high boiling points of the solvents, low volatility, and the like.

### [5. Dissolution Test and Evaluation, and Film Formability Test and Evaluation (Mixed Solvent) Part 1]

To prepare a resist material having both solubility and film formability, the first solvent and the second solvent shown in Table 6 below were mixed at the mass ratio shown in Table 6. Regarding the solubility of the solvates 1 to 4 of the polyacid salts in the prepared mixed solvent, a solubility test and evaluation were performed in the same manner as in the above "3. Solubility Test and Evaluation".

Furthermore, using the prepared mixed solvents, the solvates 1 to 4 of polyacid salts were dissolved at 1% by weight to prepare resist materials. Using each resist material, a film was formed, and the film formability thereof was evaluated according to the same evaluation criteria as in the above "4. Film Formability Test and Evaluation (Single Solvent)".

In Table 6, a case where the evaluations of the solubility test and the film formability test were both A or B was evaluated as good. On the other hand, a case where the evaluation of either the solubility test or the film formability test was C was evaluated as poor.

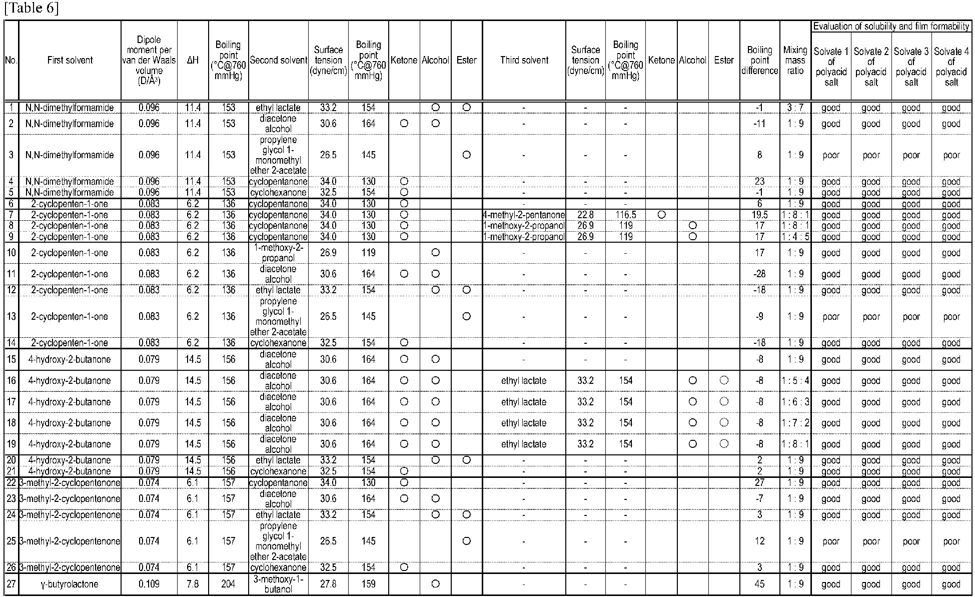

In the resist materials using the mixed solvents of Nos. 3, 13, and 25 in Table 6, propylene glycol-1-monomethyl ether-2-acetate, which is an ester solvent, was used as the second solvent, and the film formability evaluation was not good, and the overall evaluation was poor.

Furthermore, as in the mixed solvents of Nos. 1, 2, 4 to 12, 14 to 24, 26, and 27 in Table 6, when a ketone or alcohol solvent having a surface tension in the range of 20 to 35 dyne/cm and a boiling point of 165°C or less was used as the second solvent in addition to the first solvent, the solubility and film formability were good in all cases.

Furthermore, Nos. 7 to 9 and 16 to 19 in Table 6 are three solvent systems, and when two types of second solvents were used in addition to the first solvent, the solubility and film formability were good. By using a three solvent system as in Nos. 7 to 9 and 16 to 19, it is possible to finely adjust the film formability.

### [6. Dissolution Test and Evaluation, and Film Formability Test and Evaluation (Mixed Solvent) Part 2]

Next, with respect to solvates 10 to 12 of the polyacid salts, resist materials were prepared using the mixed solvents listed in Table 7 below so that the polyacid salts were present at 1% by weight, the resist materials were used to form films, and the film formability of each film was evaluated according to the same evaluation criteria as described above.

In Table 7, a case where the evaluation of the film formability test was A or B was evaluated as good. On the other hand, a case where the evaluation of the film formability test was C was evaluated as poor.

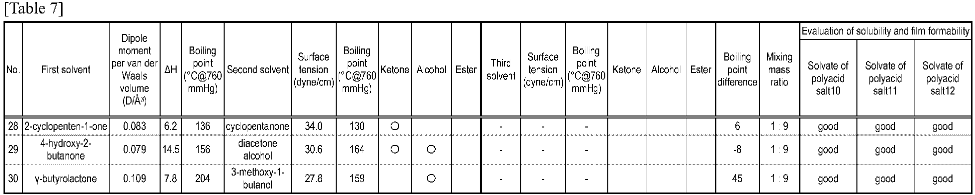

The results of Table 7 show that even when the polyacid salt is dissolved in the first solvent and concentrated, and a mixed solvent of the first solvent and the second solvent is added thereto to prepare a resist material as in the solvates 10 to 12 of the polyacid salts, the resist material can have high solubility and film formability.

These results show that the effect of improving the solubility in a mixed solvent of the first solvent and the second solvent can be obtained even when the solvate of the polyacid salt is used after being dissolved or dispersed in the first solvent and then precipitated as a solid or is used after being stored as a concentrate, and a resist material having good film formability can be provided by incorporating the solvate of the polyacid salt, the first solvent, and the second solvent into the resist material.

## Claims

1. A resist material comprising:
(A) a polyacid salt or a solvate thereof; (B) a first solvent; and (C) a second solvent,
wherein the first solvent is a solvent having a dipole moment (D) per van der Waals volume (Å³) of 0.055 D/Å³ or more and a hydrogen-bonding term (ΔH) in a Hansen solubility parameter of 17 MPa^{1/2} or less, and
the second solvent is a solvent different from the first solvent and is a ketone or alcohol solvent having a surface tension in the range of 20 to 35 dyne/cm and a boiling point of 165°C or less.

2. The resist material according to claim 1, wherein a boiling point difference between the first solvent and the second solvent is 50°C or less.

3. The resist material according to claim 1, wherein a boiling point difference between the first solvent and the second solvent is 30°C or less.

4. The resist material according to claim 1, wherein an anion moiety of the polyacid salt is an isopolyoxomolybdate anion, an isopolyoxotungstate anion, an isopolyoxoniobate anion, an isopolyoxotantalate anion, a heteropolyoxomolybdate anion, a heteropolyoxotungstate anion, a heteropolyoxovanadate anion, a heteropolyoxoniobate anion, or a heteropolyoxotantalate anion.

5. The resist material according to claim 1, wherein a cation moiety of the polyacid salt is an onium cation.

6. The resist material according to claim 5, wherein the onium cation is an organic sulfonium cation, an organic iodonium cation, an organic quaternary ammonium cation, or an organic phosphonium cation.

7. A method for producing a resist material, the method comprising:
dissolving a polyacid salt in one or more first solvents that are good solvents for the polyacid salt to prepare a good solvent solution; and
adding a second solvent to the good solvent solution,
wherein the first solvent is a solvent having a dipole moment (D) per van der Waals volume (Å³) of 0.055 D/Å³ or more and a hydrogen-bonding term (ΔH) in a Hansen solubility parameter of 17 MPa^{1/2} or less, and
the second solvent is a solvent different from the first solvent and is a ketone or alcohol solvent having a surface tension in the range of 20 to 35 dyne/cm and a boiling point of 165°C or less.

8. A method for producing a resist material, the method comprising:
dissolving a polyacid salt in a first solvent to produce a solvate of the polyacid salt with the first solvent; and
sequentially or simultaneously dissolving the solvate of the polyacid salt in a first solvent and a second solvent,
wherein the first solvent is a solvent having a dipole moment (D) per van der Waals volume (Å³) of 0.055 D/Å³ or more and a hydrogen-bonding term (ΔH) in a Hansen solubility parameter of 17 MPa^{1/2} or less, and
the second solvent is a solvent different from the first solvent and is a ketone or alcohol solvent having a surface tension in the range of 20 to 35 dyne/cm and a boiling point of 165°C or less.

9. A method for producing a resist material, the method comprising:
dissolving a polyacid salt in a first solvent that is a good solvent for the polyacid salt to prepare a good solvent solution;
adding a solvent that is a poor solvent for the polyacid salt to the good solvent solution to precipitate a solvate of the polyacid salt; and
sequentially or simultaneously dissolving the solvate of the polyacid salt in a first solvent and a second solvent,
wherein the first solvent is a solvent having a dipole moment (D) per van der Waals volume (Å³) of 0.055 D/Å³ or more and a hydrogen-bonding term (ΔH) in a Hansen solubility parameter of 17 MPa^{1/2} or less,
the poor solvent is a solvent having a dipole moment (D) per van der Waals volume (Å³) of less than 0.055 D/Å³ or having a hydrogen-bonding term (ΔH) in a Hansen solubility parameter of more than 17 MPa^{1/2}, and
the second solvent is a solvent different from the first solvent and is a ketone or alcohol solvent having a surface tension in the range of 20 to 35 dyne/cm and a boiling point of 165°C or less.

10. The method for producing a resist material according to claim 9, wherein the poor solvent is a ketone solvent, an ether solvent, an ester solvent, an alcohol solvent, a hydrocarbon solvent, an aromatic hydrocarbon solvent, a heterocyclic solvent, a halogen solvent, or water.
